# EUROPÄISCHE PATENTSCHRIFT

(11) **EP 1 415 748 B1**
(45) Veröffentlichungstag und Bekanntmachung des Hinweises auf die Patenterteilung: **09.08.2006**
(21) Anmeldenummer: 03090047.6
(22) Anmeldetag: 25.02.2003
(51) Int. Cl.: B23K 1/20, B23K 35/00, B81B 7/00

(54) **Verfahren zum Verbinden und zur Herstellung von Mikrostrukturbauteilen geeigneten, mikrostrukturierten Bauteillagen sowie Mikrostrukturbauteil**
Method of connecting micro structured component layers suitable for making micro structered components and micro structured component
Procédé pour joindre des couches microstructurées apte à la fabrication d'un composant microstructuré et composant microstructuré

(30) Priorität: 01.11.2002 DE 10251658
(43) Veröffentlichungstag der Anmeldung: 06.05.2004
(73) Patentinhaber: ATOTECH Deutschland GmbH, 10553 Berlin (DE)
(72) Erfinder: Meyer, Heinrich, 14109 Berlin (DE); Crämer, Konrad, 14167 Berlin (DE); Kurtz, Olaf, 10627 Berlin (DE); Herber, Ralph, 12107 Berlin (DE); Friz, Wolfang, 13189 Berlin (DE); Schwiekendick, Carsten, 13599 Berlin (DE); Ringtunatus, Oliver, 12207 Berlin (DE); Madry, Christian, 10249 Berlin (DE)
(74) Vertreter: Effert, Bressel und Kollegen

(56) Entgegenhaltungen:
- EP-A- 0 206 521
- EP-A- 1 125 630
- DE-A- 10 024 111
- DE-A- 19 532 251
- US-A- 4 613 069
- US-A- 4 817 854
- US-B1- 6 220 497
- US-B1- 6 409 072

## Beschreibung

Die Erfindung betrifft ein Verfahren zum Verbinden von zur Herstellung von Mikroreaktoren, Mikromischern und Mikrowärmeaustauschern gemäß dem Oberbegriff des Anspruchs 1, sowie ein Mikrostrukturbauteil gemäß dem Oberbegriff des Anspruchs 25 (siehe, z.B., DE-A-100 24 111).

Mikrostrukturbauteile, d.h. Mikro-(µ)-Reaktoren, µ-Mischer und µ-Wärmeaustauscher werden bereits in der chemischen Verfahrenstechnik sowohl in der Forschung als auch in Entwicklungsprojekten eingesetzt. Die ersten industriellen Prozesse sind bereits realisiert. So hat die Firma Clariant/Schweiz gemeinsam mit der Firma CPC/ Deutschland eine Pilotanlage zur Herstellung von zwei kommerziellen Azo-Pigmenten installiert und das kontinuierlich arbeitende Verfahren getestet. Das Ergebnis dieses Verfahrens besteht darin, dass bis zu 149 % mehr Farbintensität, glänzendere und transparentere Partikel etc. erreicht werden (CHEmanager, 5/2002). Einen Überblick hinsichtlich Potenzial der Mikrostrukturtechnologie und gegenwärtiger industrieller Anwendungen der Mikroreaktionstechnologie gibt die PAMIR Studie (PAMIR: Potential and Applications of Microreaction Technology - A Market Survey, Institut für Mikrotechnik Mainz GmbH and YOLE Developpement; 2002). Für weitergehende Informationen zu Forschungs- und Entwicklungsprojekten werden hier stellvertretend Ehrfeld et al., *"Microreactors",* Wiley-VCH, 2000 sowie die Proceedings der seit 1997 jährlich stattfindenden Konferenz mit dem Titel "Microreaction Technology" (IMRET 1 bis 6 in den Jahren 1997 bis 2002) genannt.

Im Vergleich zu konventionellen Reaktoren und Wärmeaustauschern zeichnen sich Mikrostrukturbauteile durch herausragende Vorteile aus:
1. Nahezu isothermes Verhalten
2. Hohes Oberflächen/Volumenverhältnis
3. Um Größenordnungen bessere Wärmeübertragung, d.h. extrem kompakte Hochleistungswärmetauscher für unterschiedlichste Anwendungen, z.B. für Brennstoffzellen, Klimaanlagen in Autos und Flugzeugen, Kühler für elektronische Bauteile mit hoher Wärmeentwicklung.
4. Extrem kompakte Bauweise
5. Höchste Systemintegration
6. Verbesserte Prozesskontrolle
7. Sehr hoher Sicherheitsstandard, auch bei stark exothermen Reaktionen
8. Verbesserter Umweltschutz

Mikrostrukturbauteile bestehen im allgemeinen aus einem Stapel dünner metallischer Bleche, die sich durch feine Strukturen auszeichnen. Durch Fügen der strukturierten Bleche entstehen Bauteile mit sehr feinen Kanälen, wobei der Querschnitt typischerweise weniger als 1 mm² beträgt. Die Bleche können durch Trokkenätzverfahren, durch nasschemische Tiefenätztechnik oder durch mechanische Mikrofertigung strukturiert werden.

Üblicherweise werden die strukturierten Bleche mit einer Deck- und einer Bodenplatte versehen und zu einem kompakten Bauteil gefügt. Bei entsprechender Konstruktion der Bauteile lässt sich ein maximaler Wärme- bzw. Leistungsaustausch bei minimalem Bauteilvolumen erzielen, wobei die Strömungsbedingungen in dem Bauteil definiert einstellbar und nahezu isotherme Bedingungen in den Mikrokanälen erreichbar sind.

Auf Grund der im folgenden beschriebenen Fertigungstechniken werden µ-Reaktoren, µ-Wärmeaustauscher und µ-Mischer meist aus speziellen Edelstählen angeboten. Darüber hinaus konnten die Mikrostrukturbauteile mit diesen Fertigungstechniken keinen breiten Anwendungsfeldern zugänglich gemacht werden, zum einen, weil eine kostengünstige Herstellung für Großserien- und Massenproduktion nicht möglich ist und/oder hohe Stückzahlen gar nicht oder nur mit extrem hohen Investitionen realisierbar sind, und zum anderen muss das Herstellungsverfahren zu Bauteilen führen, die folgenden technischen Anforderungen genügen:
1. Dichtigkeit, sowohl zwischen Mikroströmungskanälen als auch zur Umgebung,
2. Druckbeständigkeit bzw. Festigkeit,
3. Korrosionsbeständigkeit gegenüber den verwendeten Medien,
4. Temperaturbeständigkeit,
5. Freie geometrisch wohldefinierte Fluidkanäle, d.h. Kanäle, die frei sind von störenden Rückständen aus dem Herstellprozess.

Nach dem Stand der Technik wird zur Herstellung metallischer µ-Reaktoren, - Mischer und -Wärmeaustauscher ausschließlich das Thermodiffusionsschweißen als Fügetechnik der gestapelten Metallfolien verwendet. Hierbei wird der zu fügende Blechstapel aus einzelnen mikrostrukturierten Folien im Hochvakuum unter hohem Druck bei hohen Temperaturen über Interdiffusion miteinander verschweißt. Der Vorteil dieses Verfahrens besteht darin, dass Monolithe, d.h. Bauteilkerne aus einem einheitlichen Werkstoff, erzeugt werden. Um die Interdiffusion im ausreichenden Maße zu gewährleisten, werden sehr hohe Anforderungen an die Oberflächengüte (Rauheit, Reinheit, Formgenauigkeit/Planarität) beim Thermodiffusionsschweißen an die zu fügenden Bauteile gestellt. Dies führt zu Restriktionen bei der Materialauswahl, aufwendigen Prozessbedingungen und Materialvorbehandlungen. Im Falle des Aluminiums und seinen Legierungen ist dies besonders dramatisch, da die hohe Sauerstoffaffinität der Aluminiumwerkstoffe zur Ausbildung von Oxidschichten führt, selbst wenn unter guten Vakuumbedingungen gearbeitet wird. Bislang führt dieses Problem zu hohen Ausschussraten bei der Produktion, so dass dieses Fügeverfahren für industrielle Anwendungen unwirtschaftlich ist. Der sich anschließende Housing-Prozess (Bilden eines Verbundes des Gehäuses inklusive Anschlüssen mit dem Reaktorkörper), typischerweise durch Elektronenstrahlschweißen, ist dieser Restriktion noch stärker unterworfen, da Materialkombinationen innerhalb eines Bauteils nur schwer möglich sind und durch sehr starke lokale Wärmeentwicklungen Undichtigkeiten an den Diffusionsschweißnähten des Reaktorkörpers auftreten können. Nachteile des Thermodiffusionsschweißens sind demnach die nachfolgend aufgeführten aufwendigen Herstellbedingungen: Hochvakuum, bevorzugt sehr hohe Fügetemperaturen (~1000°C), lange Stand- und Prozesszeiten und Einschränkungen bezüglich der Grundmaterialien und Materialkombinationen. Die daraus resultierenden Kosten solcher Produkte schränken den Einsatz sehr drastisch ein. Die Preise solcher Bauteile liegen derzeit daher zwischen einigen hundert bis einigen tausend € (z.B. gemäß der Preisliste des Instituts für Mikrotechnik Mainz).

Lötverfahren haben zwar den Nachteil, dass die Fügeschicht aus anderen Metallen besteht als die gestapelten Folien. Diese Verfahren bieten aber unter Kostengesichtspunkten grundsätzliche Vorteile. Obwohl Lötverfahren schon mehrfach als Fügetechnik für Mikrostrukturbauteile vorgeschlagen wurden, ist es bislang nicht gelungen, Lötverfahren zur industriellen Herstellung von µ-Bauteilen einzusetzen, da die Anforderungen bei der Herstellung von µ-Bauteilen sehr hoch sind:
1. Es darf kein Lot beim Schmelzvorgang in die Kanäle laufen, so dass die Kanäle verstopfen.
2. Es sollte unbedingt ohne Flussmittel gearbeitet werden, da Flussmittelrückstände aus dem fertigen Bauteil nicht oder nur mit erheblichem Aufwand entfernt werden können.
3. Die Lotschicht muss wegen der geringen Dimensionen und der Komplexität der Struktur sehr dünn, homogen, gleichverteilt und trotzdem fehlerfrei sein.

Von Humpston (Humpston, G.J., Jacobson, D.M., *"Principles of Soldering and Brazing",* 4 (2001), ASM International, The Materials Information Society, ISBN 0-87170-462-5) wird das Transient Liquid Phase Bonding näher beschrieben. Dabei handelt es sich um ein Diffusionsschmelzlötverfahren, bei dem eine oder zwei Lotschichten zwischen den zu verbindenden Teilen erzeugt werden und der Verbund auf eine Temperatur über den Schmelzpunkt des Lotmaterials hinaus erwärmt wird. Um eine Interdiffusion der Metalle des Lots und der Grundmaterialien zu ermöglichen, wird der Verbund über eine längere Zeit erwärmt. Falls zwei verschiedene Lotmetalle oder -legierungen verwendet werden, kann auch ein Eutektikum der beiden Metalle oder Legierungen gebildet werden. Es wird angegeben, dass für die meisten Lötprozesse Kupfer, Silber oder Gold als Lot verwendet werden. Ein typisches Beispiel für ein Lot zur Anwendung in einem Diffusionsschmelzverfahren ist das Legierungssystem Kupfer/Zinn.

In CH 690 029 A5 ist eine schmelzbare Schicht aus mindestens zwei Lagen auf einem Substrat, insbesondere verwendbar zum Löten, beschrieben. Die hergestellten Substrate können vorteilhaft zum gas- und flüssigkeitsdichten Verbinden von Uhrengehäuseteilen durch Hartlöten eingesetzt werden. Zur Herstellung der Lotschicht werden zwei Teilschichten elektrolytisch abgeschieden. Die Schichten bilden beim Lötprozess ein Eutektikum, das einen Schmelzpunkt bei den für das Löten üblichen Temperaturen hat, d.h. im allgemeinen einen Schmelzpunkt oberhalb von 450°C und unterhalb von ca. 1000°C. Für die Lotschicht werden zum Löten von Weißgold, rostfreiem Stahl und Titan- und Titanlegierungen mit hohem Titan-Anteil als Komponenten Gold und Nickel in einem Verhältnis von etwa 7 : 3 angegeben. Andere Metallkombinationen, die für das Löten einsetzbar sind, sollen beispielsweise Mangan und Kupfer sowie Kupfer und Silber sein. Wird eine Gold/Nickel-Schicht auf Edelstahl aufgebracht, soll zunächst vorzugsweise eine Goldhaftschicht auf das Substrat abgeschieden werden.

Weiterhin ist in EP 0 212 878 A1 ein Verfahren zur Herstellung eines Wärmetauschers beschrieben, in dem Strömungskanäle für das Wärmemedium in Stahlplatten gebildet sind. Die Stahlplatten werden durch Diffusionsbonden miteinander verschweißt.

Wie bereits erwähnt werden derzeit fertigungsbedingt überwiegend Mikrostrukturbauteile aus Edelstahl gefertigt und angeboten. Eine besondere Herausforderung in der Fertigung von Mikrostrukturbauteilen stellt aber die Verwendung von Aluminium/Aluminiumlegierungen insbesondere für das Fügen dar. Bislang konnten noch keine mikrostrukturierten Bauteile aus Aluminium-Werkstoffen gefertigt werden, die den oben genannten technischen Anforderungen genügen. Aus diesem Grunde soll auf dieses Problem an dieser Stelle näher eingegangen werden:

Die geringe Dichte (2,7 g/cm³) des Aluminiums bei gleichzeitig günstigen Festigkeitseigenschaften ermöglicht einen optimalen Form- und Stoffleichtbau und damit wesentliche Gewichtseinsparungen. Diese Massenreduktion des Bauteils ist für Anwendungsbereiche im Fahrzeugbau sowie der Luft- und Raumfahrttechnik von außerordentlicher Bedeutung. Neben seiner Verbindung von Leichtigkeit mit großer Festigkeit zeichnet sich Aluminium durch einen stark elektropositiven Charakter und entsprechend durch eine hohe Affinität zum Luftsauerstoff aus. Im Unterschied zu leicht korrodierbarem Stahl ist Aluminium durch Ausbildung einer zusammenhängenden, dünnen Oxidschicht an Luft beständig, da diese einen weiteren Angriff des Sauerstoffs und damit eine Korrosion verhindert.

Eben diese für die hohe Korrosionsbeständigkeit des Aluminiums verantwortliche Schutzschicht verhindert den erfolgreichen Verbund von Aluminiumlagen oder -teilen bei der Herstellung von Mikrostrukturbauteilen oder führt zu hohen Ausschussraten und muss deshalb unbedingt vor dem Fügeprozess entfernt werden. Hierzu werden z.B. beim Löten Flussmittel eingesetzt, die üblicherweise bei Temperaturen von ca. 570°C aufschmelzen und die Al-Oxidschicht auflösen. Da mit dem Einsatz von Flussmitteln erhebliche Nachteile, wie z.B. hohe Umweltbelastung, Korrosion, unerwünschte Reaktionen zwischen Flussmittel und z.B. Legierungsbestandteilen des Grundmaterials sowie hierdurch entstehende Zusatzkosten, verbunden sind, ist auf dessen Verwendung nach Möglichkeit zu verzichten. Darüber hinaus können größere Flächen unter Zusatz von Flussmitteln oftmals nur unzulänglich miteinander verbunden werden, da es zu Anreicherungen durch unvollständigen Ablauf des Flussmittels beim Fügeprozess kommen kann und damit die Korrosionswahrscheinlichkeit extrem ansteigt. Aus diesen Gründen wurden auch Verfahren entwickelt, in denen flussmittelfrei gelötet werden kann. Alle diese Verfahren konnten jedoch bislang nicht zur erfolgreichen Herstellung mikrostrukturierter Bauteile verwendet werden.

Wegen der großen Bedeutung der Aluminiumwerkstoffe wird gegenwärtig intensiv an der Lösung der Problematik des Fügens mikrostrukturierter Bauteile aus Aluminium/Aluminiumlegierungen geforscht.

Allgemein wird Löten großtechnisch bereits als thermisches Fügeverfahren im Vakuum oder in Inertgasatmosphäre eingesetzt. Die hierbei verwendeten Lotfolien oder Lotpasten führen beim Löten der Mikrostruktur jedoch leicht zu einer Verstopfung der Mikrokanäle, so dass dieses Verfahren für den Einsatz als Fügeverfahren von Mikrostrukturbauteilen nicht geeignet ist. Ferner kann der Zusatz von üblicherweise beim Löten eingesetzten Flussmitteln zur Korrosion der Lötverbindung führen, da die Flussmittel im Lotspalt der Mikrokanäle angereichert werden. Überdies stellen Flussmittel eine hohe Umweltbelastung dar, die nur durch eine aufwendige und teure Abwasser- und Abluftreinigung minimiert werden kann. Darüber hinaus kann es zu unerwünschten Reaktionen zwischen dem Flussmittel und den Legierungszusätzen kommen, so dass der angestrebte Verbund zwischen den Fügepartnern nicht mit den gewünschten Eigenschaften zustande kommt. Bei der Herstellung katalytisch beschichteter Mikroreaktoren kann die Verwendung von Flussmitteln außerdem zur Deaktivierung des verwendeten Katalysators führen.

Zum Fügen von Aluminium und/oder Aluminiumlegierungen ist beispielsweise in US 2002/0012811 A1 angegeben, dass das Material an den zu verbindenden Oberflächen zunächst vorbehandelt wird und auf die vorbehandelten Oberflächen dann eine Nickel enthaltende Metallschicht elektrolytisch aufgebracht wird, die außerdem Wismut enthält. Das Fügeverfahren kann ohne Flussmittel durchgeführt werden. Die mit Nickel/Wismut beschichteten Aluminiummaterialien können zur Herstellung von Wärmetauschern eingesetzt werden.

Von Steffens, H.-D., Wilden, J., Möhwald, K., *"Einsatz von ionenplaitierten Diffusionsbarrieren und Belotungssystemen beim Löten von Stahl*/*Leichtmetallverbindungen"* (DVS, 166, 94-98 (1995)) wird angegeben, dass eutektische Aluminiumbasislote zum flussmittelfreien Löten eingesetzt werden können. Vor dem Aufbringen des Aluminiumbasislots werden mittels TiNi-lonenplattierungen eine Titanschicht als Haftvermittler und eine Nickelschicht als benetzungsfähige Oberfläche, die auch als Diffusionsbarriere wirkt, aufgebracht.

Von Petrunin, I.E., *"Kontakt-Reaktionslöten",* Handbuch Löttechnik, Verlag Technik GmbH Berlin, 1990, werden Techniken zum Löten von Aluminium und dessen Legierungen angegeben. Danach kann Aluminium ohne Flussmittel in einer Gasatmosphäre durch das Kontaktreaktionsverfahren ohne Anwendung von Oberflächenschutzschichten gelötet werden. Als Lote werden Silizium, Kupfer oder Silber eingesetzt, die elektrolytisch, durch Bedampfen oder durch Siebdruck auf die Aluminiumoberfläche aufgetragen werden. Oberflächenschutzschichten, beispielsweise Schichten aus Aluminium, Kupfer, Nickel, Silber, Zink u.ä., können ebenfalls dann verwendet werden, wenn auf das Flussmittel verzichtet werden soll. Auch diese Schichten können elektrolytisch oder chemisch gebildet werden.

In DE 197 08 472 A1 ist ein Herstellverfahren für chemische Mikroreaktoren beschrieben, bei dem Fluidkanäle in einzelnen Ebenen gebildet werden. Die einzeln hergestellten Ebenen werden anschließend zu einem Stapel zusammengefasst und beispielsweise durch Löten fest miteinander verbunden. Die einzelnen Substrate können aus Metallen/Metalllegierungen bestehen. Zum Fügen der einzelnen Lagen werden u.a. ein Hartlötverfahren unter Verwendung von Silber enthaltendem Lot sowie ein Verfahren erwähnt, bei dem zunächst eine Zinnschicht und darauf eine Wismutschicht abgeschieden werden. In diesem Falle bildet sich beim Erwärmen der Schichten an der Grenzfläche ein niedrig schmelzendes eutektisches Gemisch und bei weiterem Tempern eine Lötverbindung, die einen erhöhten Schmelzpunkt aufweist.

Zum Herstellen eines Wärmetauschers für einen Stirlingmotor werden gemäß Bocking, C., Jacobson, D., Bennett, G., *"Layer manufacturing of heat exchange elements using photochemical machining, electroplating and diffusion brazing",* Trans. IMP, 2000, 78(6), 243-246, Kupferbleche verwendet, in denen durch chemisches Ätzen Fluidströmungskanäle gebildet werden. Die Bleche werden durch ein Diffusionslötverfahren miteinander verbunden. Hierzu wird auf die Kupferbleche Zinn elektrolytisch abgeschieden, und die Bleche werden unter Wärmeeinwirkung miteinander verlötet.

Von Bartels, F., Muschik, T., Gust, W., *"Untersuchungen thermisch stabiler Mikroverbindungen aus intermetallischen Phasen",* DVS, (1991), 141, 22-24, wird über ein Lötverfahren berichtet, bei dem intermetallische Phasen binärer Systeme gebildet werden, deren Komponenten stark unterschiedliche Schmelzpunkte aufweisen. Als Beispiele werden hierfür die binären Systeme Cu(Sn), Pt(Sn), Ni(Sn) und Ni(In) angegeben. In dem Bericht wird das System Cu(Sn) näher beschrieben.

Es ist daher besonders erwähnenswert, dass es trotz einer Vielzahl von Arbeiten, die auf dem Gebiet der Fügeverfahren durchgeführt wurden, bis heute nicht gelungen ist, die zuvor aufgeführten Anforderungen zur Herstellung von Mikrostrukturbauteilen zu erfüllen, und dies, obwohl Mikrostrukturbauteile bereits seit geraumer Zeit als vielversprechende Konstruktionselemente für eine Vielzahl von Anwendungen diskutiert und gefertigt werden.

Trotz des erheblichen Bedarfs, derartige Bauteile für die einzelnen Anwendungen einzusetzen, ist es bis heute nicht gelungen, die Mikrostrukturbauteile in nennenswerter Stückzahl zu vertretbaren Kosten herzustellen. Ein Grund hierfür besteht darin, dass die verfügbaren Fügetechniken zum Verbinden der einzelnen Bauteillagen bisher nicht geeignet waren, die Mikrostrukturbauteile mit vertretbarer Ausbeute herstellen zu können. Die Probleme bestehen darin, dass die vorgenannten Anforderungen nicht zufriedenstellend erfüllt werden können. Beispielsweise ist es nicht ohne weiteres möglich, eine ausreichende Druckbeständigkeit mit ausreichender Gas- und Fluiddichtigkeit sowohl zwischen den Mikroströmungskanälen als auch zur Umgebung (beispielsweise: He-Lecktest: 1.10⁻⁸ mbar·l/s) zu erreichen und gleichzeitig zu gewährleisten, dass die Mikrokanäle von dem Fügemittel, beispielsweise einem Lot, völlig freibleiben und nicht verstopfen.

Von daher besteht das der vorliegenden Erfindung zugrunde liegende Problem darin, dass die bekannten Herstellverfahren für Mikrostrukturbauteile nicht ausreichend zuverlässig sind, um zu gewährleisten, dass die Druck- und Korrosionsbeständigkeit des Bauteils genügend hoch ist, dass die Dichtigkeit des Bauteils gegen Fluidaustritt aus dem Bauteil oder Fluidübertritt in benachbarte Mikrokanäle genügend hoch ist und dass die Mikrokanäle einen ausreichend geringen Strömungswiderstand aufweisen. Darüber hinaus sind die bekannten Herstellungsverfahren nicht so kostengünstig, dass die mikrostrukturierten Bauteile breiteren Anwendungsfeldern zugeführt werden können.

Die beschriebenen Probleme werden gelöst durch das Verfahren nach Anspruch 1 und durch das Mikrostrukturbauteil nach Anspruch 25. Bevorzugte Ausführungsformen der Erfindung sind in den Unteransprüchen angegeben.

Die Mikrostrukturbauteile bestehen im allgemeinen aus einer Vielzahl von Bauteillagen, die gas- und flüssigkeitsdicht miteinander verbunden sind, wobei sich in dem Bauteil Mikrokanäle für Fluide, insbesondere Strömungskanäle für Fluide und andere Hohlräume, befinden, die für die Funktionalität der Bauteile verantwortlich sind.

Soweit nachfolgend in der Beschreibung und in den Ansprüchen auf ein Lötverfahren Bezug genommen wird, ist darunter ein Verfahren zu verstehen, bei dem die Fügepartner unter Hinzufügung eines weiteren Materials (Lot) verbunden werden, wobei das Lot zumindest anfänglich in schmelzflüssiger Form in der Fügenaht vorliegt. Es wird zwischen Hartlöt- und Weichlötverfahren unterschieden: Beim Hartlötverfahren wird ein Lot verwendet, das einen Schmelzpunkt aufweist, der zumindest anfänglich über 450°C liegt. Beim Weichlötverfahren liegt dieser Schmelzpunkt zumindest anfänglich bei höchstens 450°C.

Soweit nachfolgend in der Beschreibung und in den Ansprüchen auf eine hochschmelzende Lotschicht Bezug genommen wird, ist darunter ein Material zu verstehen, dass einen Schmelzpunkt oberhalb von 450°C aufweist. Soweit nachfolgend auf eine niedrigschmelzende Lotschicht Bezug genommen wird, ist darunter ein Material zu verstehen, dass einen Schmelzpunkt von maximal 450°C aufweist.

Das beanspruchte Verfahren dient dazu, mikrostrukturierte Bauteillagen für ein Mikrostrukturbauteil durch Löten miteinander zu verbinden. Zur Herstellung der erfindungsgemäßen Mikrostrukturbauteile werden die mikrostrukturierten Bauteillagen auf Fügeflächen zunächst mit mindestens einer multifunktionalen Barriereschicht und auf der mindestens einen Barriereschicht dann mit einer Lotschicht versehen, dann die derart vorbereiteten Bauteillagen gestapelt und unter Wärmeeinwirkung miteinander verlötet.

Somit entsteht ein Mikrostrukturbauteil, das aus einem Stapel von miteinander gefügten, aus Stoffen, ausgewählt aus der Gruppe, umfassend Metalle und Metaillegierungen, bestehenden mikrostrukturierten Bauteillagen besteht und das mindestens eine multifunktionale Barriereschicht sowie eine Lotschicht zwischen den einzelnen Bauteillagen aufweist. Die vorliegende Erfindung beruht somit auf einem Fügeverfahren für Mikrostrukturbauteile aus Bauteillagen, die mindestens eine multifunktionale Barriereschicht insbesondere auf den Fügeflächen der einzelnen Bauteillagen und eine darauf aufgebrachte Lotschicht aufweisen.

Bei Anwendung bekannter Fügetechniken hat es sich herausgestellt, dass die Fügeverbindungen insbesondere dann, wenn das Mikrostrukturbauteil unter hohem Betriebsdruck steht, nicht ausreichend beständig sind. Es ist vor allem beobachtet worden, dass das im Bauteil prozessierte Fluid häufig dann aus dem Bauteil austritt, wenn der Betriebsdruck im Bauteil relativ hoch ist. In vielen Fällen ist auch festgestellt worden, dass Fluid von einem Strömungskreislauf im Bauteil in einen anderen Strömungskreislauf übertritt, weil keine ausreichende Dichtigkeit zwischen den unterschiedlichen Strömungskreisläufen erreicht werden kann. Die Ursachen hierfür sind nicht ohne weiteres ermittelbar gewesen. Eine mögliche Ursache ist darin gesehen worden, dass die Fügeflächen in den Mikrostrukturbauteilen äußerst klein sind, weil die Mikrokanäle durch die hohe Integrationsdichte des Mikrostrukturbauteils auf sehr engem Raum untergebracht werden müssen. Somit hat als Maßnahme zur Behebung dieses Mangels nahegelegen, das Strömungskanaldesign so zu verändern, dass eine ausreichend große Fügefläche zwischen den einzelnen Mikrokanälen zur Verfügung steht. Diese Optimierung ist jedoch schnell an Grenzen gestoßen, da die Freiheit, das Design in der gewünschten Weise zu verändern, durch die Anforderungen an die Integrationsdichte der Mikrostrukturbauteile stark beschränkt ist.

Durch sehr sorgfältiges Diffusionsbonden von aus Stahl- oder Kupferblechen bestehenden Mikrostrukturbauteilen ist das Problem mit den bereits erwähnten Einschränkungen gelöst worden. Es hat sich aber zum einen das weitere Problem herausgestellt, dass nur äußerst ebene Stahl- oder Kupferbleche mit hoher Oberflächengüte zum gas- und flüssigkeitsdichten Verbinden der Bleche geeignet sind, während der Fügevorgang bei Verwendung von Blechen mit unterschiedlicher und insbesondere geringerwertiger Oberflächengüte nicht zum gewünschten gas- und flüssigkeitsdichten Verbinden der Bleche führt. Außerdem sind insbesondere Aluminiumbleche und Bleche aus Aluminiumlegierungen dann überhaupt nicht mehr geeignet, wenn es auf die Gas- und Flüssigkeitsdichtigkeit des Mikrostrukturbauteils bei Anwendung eines hohen Innendruckes ankommt.

Die beschriebenen Probleme sind durch Herstellen des beschriebenen Schichtaufbaus aus multifunktionaler Barriereschicht und Lotschicht erstmals gelöst worden:

Es ist festgestellt worden, dass die multifunktionale Barriereschicht eine Diffusion der Elemente der Lotschicht in das Metallgrundmaterial ebenso verhindert wie eine Diffusion der Elemente des Metall-Grundmaterials in die Lotschicht. Dadurch werden insbesondere eine Verarmung der schmelzflüssigen Phase an bestimmten Metallspezies beim Löten und somit unerwünschte Wechselwirkungen zwischen der Lotschicht und dem Grundmaterial vermieden. Außerdem wird auch verhindert, dass sich im Grundmaterial und/oder in der Lotschicht Sprödphasen durch Interdiffusion ausbilden. Außerdem wird auch verhindert, dass die schmelzflüssige Lotphase durch Diffusion von Lotbestandteilen in das Grundmaterial verarmt und somit ein fester Verbund zwischen dem Lot und dem Grundmaterial verhindert wird. Weiterhin wird dadurch auch erreicht, dass die Fügepartner ohne Anwendung eines Flussmittels gelötet werden können. Durch die Barriereschicht wird nämlich auch eine Oxidation des Grundmaterials verhindert.

Das erfindungsgemäße Fügeverfahren dient zur Herstellung mikrostrukturierter Bauteillagen und von Mikrostrukturbauteilen unter materialschonenden Bedingungen. Neben Kupfer und/oder Kupferlegierungen und Edelstählen ermöglicht es auch erstmals, Aluminium sowie Aluminiumlegierungen als kostengünstige Werkstoffe für Mikrostrukturbauteile wirtschaftlich zu verwenden. Während die Herstellung von Mikrostrukturbauteilen im Falle von Aluminium und Aluminiumlegierungen durch das erfindungsgemäße Fügeverfahren überhaupt erst ermöglicht wird, bietet es bei Verwendung anderer Metalle und Metalllegierungen alle Vorteile eines Niedrigtemperaturprozesses. Hierdurch können Prozesskosten durch Einsparungen bei den Energiekosten gesenkt und die Umwelt geschont werden. Ferner kann auf die Verwendung teurer Hochtemperaturwerkstoffe zum Bau eines Hochtemperaturofens verzichtet und damit die Höhe der Anfangsinvestitionen für die Ausrüstung für den Herstellungsprozess gesenkt werden. Darüber hinaus erhöht der schonende Prozess bei niedrigen Fügetemperaturen die Formstabilität der Bauteile bei gleichzeitiger Erfüllung hoher technologischer Qualitätsanforderungen an Dichtigkeit, Festigkeit und insbesondere Korrosionsstabilität.

Das erfindungsgemäße Fügeverfahren löst die eingangs erörterten Probleme, die durch die Bildung einer Oxidschicht auf Aluminiumwerkstoffen entstehen, im speziellen auch für das Fügen dieser Werkstoffe, und genügt dabei nicht nur den technischen Anforderungen an das Produkt und das Herstellverfahren und insbesondere an das Fügeverfahren, sondern auch dem Anspruch, eine Möglichkeit zur industriellen und kostengünstigen Fertigung zu bieten. Nur in diesem Fall können für die Mikrostrukturbauteile breite Anwendungsfelder in der Zukunft nachhaltig erschlossen werden.

Die multifunktionale Barriereschicht wird aus mindestens einem Metall, ausgewählt aus der Gruppe, umfassend Molybdän, Mangan, Chrom, Palladium, Eisen, Nickel und Legierungen von Eisen und/oder Nickel mit Phosphor, gebildet. Wird die Löttemperatur nicht zu hoch gewählt, so findet praktisch keine Interdiffusion der Elemente der Barriereschicht in das Grundmaterial hinein oder aus dem Grundmaterial heraus statt.

Die multifunktionale Barriereschicht weist insbesondere eine Dicke von etwa 1-10 µm auf. Durch die multifunktionale Barriereschicht können dann Unebenheiten auf dem Grundmaterial ausgeglichen werden, wenn das Material in ausreichender Dicke abgeschieden wird. Somit bildet die Barriereschicht in diesem Falle auch eine homogene Grundlage für die darauf abzuscheidende Lotschicht. Weiterhin vermittelt die Barriereschicht auch die Haftfestigkeit zwischen dem Grundmaterial und der Lotschicht. Unter Wärmeeintrag bildet die Barriereschicht nämlich einen festen Verbund mit dem Grundmaterial. Dadurch wird die Grundlage für eine ausreichende Druckstabilität und Festigkeit des Mikrostrukturbauteils gelegt.

Die multifunktionale Barriereschicht kann insbesondere mittels galvanotechnischer Methoden erzeugt werden. Als galvanotechnische Methode beispielsweise zur Abscheidung der Barriereschicht wird vorzugsweise ein elektrolytisches, außenstromloses oder zementatives Metallabscheideverfahren angewendet. Unter einer außenstromlosen Metallabscheidung wird ein Verfahren verstanden, bei dem ohne äußere Einwirkung von elektrischem Strom Metall abgeschieden wird. Unter einem zementativen Verfahren wird beispielsweise ein Verfahren verstanden, bei dem das Metall aus einem Abscheidebad abgeschieden wird, das zur Metallabscheidung ein Reduktionsmittel enthält. Unter einem zementativen Verfahren wird beispielsweise auch ein Verfahren verstanden, bei dem das Metall aus einem Abscheidebad abgeschieden wird, das kein Reduktionsmittel für das Metall enthält, wobei das Metall jedoch durch Ladungsaustausch mit der Oberfläche des Grundmaterials abgeschieden wird. Das Metall scheidet sich in diesem Falle also unter Auflösung des Grundmaterials ab. Da die Schichtdicke von abgeschiedenem Metall und somit auch die Menge des abgeschiedenen Materials bei Anwendung galvanotechnischer Methoden relativ einfach in engen Grenzen gehalten werden kann, kann gewährleistet werden, dass die Mikrokanäle des Mikrostrukturbauteils durch das Material der Barriereschicht nicht verstopfen.

Das Lötverfahren ist vorzugsweise ein Schmelzdiffusionslötverfahren (SDL). Darunter ist ein Lötverfahren zu verstehen, bei dem mehrere Elemente des Lotes interdiffundieren und dabei intermetallische Phasen bilden. Sofern lediglich ein reines Metall als Lot eingesetzt wird, kann dieses Metall in einen der beiden Fügepartner eindiffundieren. Auch dabei können intermetallische Phasen entstehen. Beispielsweise kann die Zusammensetzung und Dicke der Lotteilschichten beim Schmelzdiffusionslötverfahren so aufeinander abgestimmt werden, dass sich beim Fügevorgang ein initiales Eutektikum bildet. Somit wird anfänglich eine sehr niedrige Schmelztemperatur erreicht. Durch Interdiffusion der Elemente des Lotes zwischen verschiedenen Lotschichten verschiebt sich der Schmelzpunkt während des Lötprozesses nach und nach zu einem höheren Wert. Durch Tempern der Fügeverbindung wird beim Schmelzdiffusionslöten also allmählich eine feste Lötverbindung mit einem Schmelzpunkt erhalten, der wesentlich höher liegt als der sich anfänglich beim Aufschmelzen der Lotschicht einstellende Schmelzpunkt. Als besonders vorteilhaft hat es sich herausgestellt, dass eine Lotschicht hergestellt wird, die aus mindestens einer Lotteilschicht und insbesondere zwei Lotteilschichten besteht. In diesem Falle kann die multifunktionale Barriereschicht auf beiden zu fügenden Oberflächen aufgebracht sein, um die Diffusion von Elementen von dem Grundmaterial in die Fügenaht und von dort in das Grundmaterial zu verhindern. Durch Diffusion der Elemente der verschiedenen Lotteilschichten ineinander wird ein hochschmelzendes Lot erreicht. Alternativ kann die Lotschicht auch durch gemeinsame Abscheidung von mehreren Metallen gebildet werden.

Eine bevorzugte Ausführungsform der Erfindung besteht darin, als eine der Lotteilschichten hochschmelzende Lotteilschichten und als andere der beiden Lotteilschichten niedrigschmelzende Lotteilschichten vorzusehen, wobei die hochschmelzende Lotteilschicht insbesondere zuerst und die niedrigschmelzende Lotteilschicht danach abgeschieden wird. Durch diese Ausführungsform wird eine besonders hohe Festigkeit der Lötverbindung erreicht. Durch die Wahl der Zusammensetzung der Lotteilschichten kann die Wiederaufschmelztemperatur der Lötverbindung gezielt beeinflusst werden. So kann beispielsweise durch einen Überschuss an der höherschmelzenden Lotkomponente die Wiederaufschmelztemperatur durch Ausbildung fester Lösungen und/oder intermetallischer Phasen mit einem starken Überschuss an höherschmelzender Lotkomponente gezielt erhöht werden. Die für Mikrostrukturbauteile sehr wichtige Druckstabilität (Berstdruck) liegt besonders dann sehr hoch, wenn die Lotschicht aus den genannten Lotteilschichten besteht. Die Elemente der beiden Lotteilschichten werden vorzugsweise, aber nicht notwendigerweise, in der Stöchiometrie gewünschter intermetallischer Phasen miteinander kombiniert. Im Falle der Ausbildung gewünschter fester Lösungen wird die Menge der niedrigschmelzenden Komponente entsprechend minimiert. Werden die Elemente der beiden Lotteilschichten so gewählt, dass die beiden Elemente ein Eutektikum bilden können, so kann die Löttemperatur unterhalb der Schmelztemperatur jedes einzelnen Lotelements eingestellt werden, sofern die Löttemperatur oberhalb der Schmelztemperatur der eutektischen intermetallischen Phase liegt. Entspricht die Zusammensetzung der Lotteilschichten nicht ihrem Eutektikum, wird vorzugsweise die Temperatur knapp oberhalb der Schmelztemperatur der niedrigschmelzenden Lotteilschicht gewählt. Sind die Bauteilanforderungen hinsichtlich Druckstabilität und Festigkeit nicht sehr hoch, so kann die Prozesszeit in beiden oben beschriebenen Fällen dadurch verkürzt werden, dass ein Temperungsschritt (nachträgliche Temperaturbehandlung) dem verkürzten Lötprozess folgt. Dieser führt ohne zusätzlichen Anpressdruck zu verbesserten Druckstabilitäten und Festigkeiten der Bauteile, die für bestimmte Anwendungen ausreichend sein können. Ist der verfügbare Temperaturbereich des Presswerkzeugs begrenzt, so kann ein Pressvorgang auch bei geringerer Temperatur durchgeführt werden. Die nachträgliche Temperung bei höherer Temperatur ohne Presswerkzeug führt wiederum zu höheren Bauteilfestigkeiten (siehe Durchführung in Beispiel 2 c und e Der Temperungsschritt dient hierbei zur Fortführung der Interdiffusion und/oder Phasenausbildung und/oder der Ausbildung der festen Lösung als Funktion der Temperungszeit und der Temperatur nach dem verkürzten Lötprozess. Die Abkühlung kann hierbei passiv oder aktiv, z.B. durch Verwendung einer Kühlpresse, erfolgen.

Daher kann insgesamt mit einer sehr niedrigen Löttemperatur gearbeitet werden. Insbesondere dadurch wird eine sehr schonende Behandlung der einzelnen Bauteillagen erreicht, so dass ein Verzug der einzelnen Lagen, einschließlich der Basis- und Deckplatten, durch thermische Belastung praktisch auszuschließen ist. Der Temperungsvorgang (Lötprozess) wird vorzugsweise bei konstanter Temperatur (isotherm) durchgeführt. Während des Temperungsvorganges kann außerdem gleichmäßiger Druck auf die Fügepartner ausgeübt werden, um eine homogene innige Verbindung der Fügepartner miteinander zu erreichen. Um sicherzustellen, dass sich beim Löten nicht erneut Oxidschichten auf dem Grundmaterial bzw. auf der Lotschicht bilden, werden die zu lötenden Bauteile bevorzugt im Vakuum oder unter Inertgasatmosphäre (beispielsweise Argon, Stickstoff) gelötet.

Die Bauteillagen werden insbesondere durch gleichzeitige Anwendung von Wärme und Anpressdruck miteinander verbunden. Durch Bilden schmelzflüssiger Phasen beim Aufschmelzen des Lotes und einer isothermen Temperung kann eine sehr homogene Fügenaht erzeugt werden, die äußerst korrosionsbeständig ist und eine sehr hohe Festigkeit aufweist.

Die hochschmelzende und die niedrigschmelzende Lotteilschicht können ein- oder beidseitig in verschiedenen Abfolgen auf jede und/oder auf z.B. nur jede zweite Bauteillage lokal oder vollflächig aufgebracht werden. Vorzugsweise wird zuerst die hochschmelzende Lotteilschicht und dann die niedrigschmelzende Lotteilschicht aufgebracht. Wird eine Lotschicht aus mindestens einer hochschmelzenden und einer niedrigschmelzenden Lotteilschicht gebildet, so kann die hochschmelzende Lotteilschicht aus mindestens einem Metall, ausgewählt aus der Gruppe, vorzugsweise umfassend Nickel, Silber, Gold und Kupfer, gebildet werden. In diesem Falle kann die niedrigschmelzende Lotteilschicht aus mindestens einem Metall, ausgewählt aus der Gruppe, vorzugsweise umfassend Zinn, Indium und Wismut, gebildet werden.

Durch Aufschmelzen der aus den beiden Lotteilschichten bestehenden Lotschicht bildet sich somit eine intermetallische Phase, z.B. bestehend aus Gold, Silber, Nickel und/oder Kupfer einerseits und Zinn und/oder Indium und/oder Wismut andererseits. Nach ausreichend langer Interdiffusion der Metalle der hochschmelzenden und der niedrigschmelzenden Lotteilschicht beim Tempern entsteht eine Lotverbindung, die eine hohe Festigkeit und insbesondere eine hohe Schmelztemperatur aufweist, die deutlich oberhalb der Löttemperatur liegt.

Die Dicke der Lotschichten beträgt vorzugsweise etwa 1 - 20 µm. Auch die Lotschichten werden vorzugsweise durch galvanotechnische Verfahren erzeugt. Durch sorgfältige Kontrolle der Schichtdicke des abgeschiedenen Lotmaterials und somit der Menge des abgeschiedenen Materials wird gewährleistet, dass das Lot nicht in die sehr feinen Mikrokanäle der einzelnen Bauteillagen eindringt und diese verstopft. Daher ist mit dem erfindungsgemäßen Verfahren eine sichere Fertigung der Mikrostrukturbauteile mit geringem Strömungswiderstand erreichbar. Im Falle eines Ladungsaustauschverfahrens zur galvanotechnischen Bildung der Lotschichten bzw. Lotteilschichten findet ein Ladungsaustausch vorzugsweise mit der Barriereschicht statt, auf der die Lotschicht insbesondere abgeschieden wird. Falls die Barriereschicht jedoch relativ dünn ist, kann diese auch Poren aufweisen, so dass der Ladungsaustausch zumindest partiell auch mit der Grundmaterialoberfläche stattfindet.

Die Lotschichten und/oder die multifunktionale Barriereschicht können entweder ausschließlich auf den Fügeflächen der Bauteillagen abgeschieden werden oder auch auf den Wänden der Mikrokanäle in den Bauteillagen. In letzterem Falle kann die Zusammensetzung der intermetallischen Phasen, die sich beim Aufschmelzen des Lotes bilden, so gewählt werden, dass diese Phasen gleichzeitig auch als Korrosionsschutz in den Mikrokanälen wirken.

Die mikrostrukturierten Bleche können zunächst mit der multifunktionalen Barriereschicht und dann mit der Lotschicht beschichtet werden. Die beschichteten Bleche können über längere Zeit gelagert werden, ohne dass zu befürchten ist, dass die Grundmaterialoberflächen korrodieren und dann nur noch unter Zuhilfenahme von Flussmittel gelötet werden können. Auf Flussmittel kann beim Löten daher verzichtet werden. Durch die Lotschicht und insbesondere durch die multifunktionale Barriereschicht wird ein Anlaufen der Grundmaterialoberflächen sicher verhindert, so dass die Lötbarkeit über längere Zeit hinweg erhalten bleibt. Die Lotschicht wird vorzugsweise aus mehreren Lagen verschiedener Zusammensetzung durch lokale oder durch vollflächige, durch elektrolytische oder stromlose Metallabscheidung gebildet. Die mikrostrukturierten und lotbeschichteten Bauteilbleche werden schließlich so übereinandergelegt, dass ein Stapel entsteht. Zwischen den Bauteilblechen befindet sich das Lot ohne direkten Kontakt zum Grundmaterial und damit räumlich begrenzt ("eingesperrt") durch die Barriereschicht. Durch Ausüben eines gleichmäßigen Druckes auf den Stapel unter Wärmeeinwirkung schmilzt das Lot auf, so dass sich die gewünschte feste, gas- und flüssigkeitsdichte Lotverbindung bildet.

Vor der Bildung der multifunktionalen Barriereschicht und der Lotschicht wird das Grundmaterial zunächst in geeigneter Weise chemisch vorbehandelt. Beispielsweise wird das Grundmaterial entfettet und von Oberflächenoxiden gereinigt. Beispielsweise kann auch eine Zinkatbeize angewendet werden, die im wesentlichen aus einer stark alkalischen Zinkhydroxid-Lösung besteht. Anschließend wird die Barriereschicht in der weiter oben beschriebenen Art und Weise aufgebracht. Soll auf der multifunktionalen Barriereschicht ein Edelmetall als höherschmelzende Komponente der Lotschicht abgeschieden werden, muss zur Verbesserung von dessen Haftung und zur Vermeidung einer Sudabscheidung (einer zementativen Abscheidung) zuvor eine dünne Schicht eines Edelmetalls, besonders bevorzugt eine dünne Schicht des später als Lotkomponente abzuscheidenden Edelmetalls, aus einer komplexbildnerhaltigen Lösung abgeschieden werden. Danach wird die Lotschicht, wie zuvor beschrieben, abgeschieden. Hierzu werden vorzugsweise zuerst die hochschmelzende Lotkomponente, beispielsweise Kupfer, Gold, Nickel und/oder Silber, und dann die niedrigschmelzende Komponente, beispielsweise Zinn und/oder Indium und/oder Wismut, aufgebracht.

In einer bevorzugten Ausführungsform des erfindungsgemäßen Verfahrens kann nach dem fotolithografischen Prozessschritt, dem chemischen Ätzen zur Erzeugung der Mikrostruktur und der wie oben beschriebenen galvanischen Abscheidung funktionaler Schichten zum Fügen des Blechstapels und/oder der Bleche und gegebenenfalls nicht strukturierter Abschlussbleche, die gegebenenfalls Zu- und Ableitstutzen für das Fluid aufweisen, einzeln oder in Mehrfachnutzen, auf Vakuum-Laminieranlagen (Laminierpressen, z.B. RMV 125, RMV 125 der Fa. Maschinenfabrik Lauffer GmbH & Co. KG), die bereits bei der Herstellung z.B. von Multilayer-PC-Boards verwendet werden, zurückgegriffen werden. Die Herstellung von µ-Kühlern, µ-Wärmetauschern und µ-Reaktoren mit einem massenproduktionstauglichen Design kann somit mit einem kostengünstigen und massenproduktionstauglichen und erprobten Verfahren hergestellt werden.

Die Presswerkzeuge einer typischen Laminieranlage bestehen typischerweise aus zwei Platten, Lagen oder Folien aus einem Material, ausgewählt aus der Gruppe, umfassend Metalle, Keramiken, Graphit und Verbundwerkstoffe. Metallplatten und/oder Keramikplatten und/oder Graphitplatten werden insbesondere eingesetzt, wobei eine die Bodenplatte und die andere den oberen Abschluss der Pressvorrichtung bildet. Beide Pressplatten müssen die Voraussetzung vernachlässigbarer Jochbildung unbedingt erfüllen, um plane Anpressflächen zur Druckaufbringung zu gewährleisten.

Auf die Bodenplatte werden vorzugsweise hochtemperaturfeste Keramikfaserpapiere als Keramikvliese in einer Dicke von etwa 1 - 10 mm, vorzugsweise 2 - 4 mm, gelegt und als Presspolster verwendet. Hierdurch wird ein möglicher Höhenunterschied zwischen den Bauteilen ausgeglichen und eine homogene Druckverteilung erzielt. Anschließend wird eine Zwischenplatte, vorzugsweise aus Graphit, Keramik, Stahl oder Verbundwerkstoff, mit ausreichender Biegefestigkeit, Druckstabilität und Wärmeleitfähigkeit in einer Dicke von 1 - 30 mm, vorzugsweise 10 - 20 mm, auf das Keramikfaserpapier gelegt, um dessen Verbund mit den metallischen Bauteilen zu verhindern. Auf der Zwischenplatte werden die Bauteillagen entweder einzeln oder besonders bevorzugt im Mehrfachnutzen gestapelt. Sollen Folien mehrerer Bauteile einzeln oder in einem Mehrfachnutzen übereinander gestapelt gleichzeitig verlötet werden, so werden die Folien beispielsweise durch Graphit-Zwischenlagen voneinander getrennt.

Im Falle des Verlötens einzelner Stapel wird der Versatz der einzelnen Folien durch die Verwendung spezieller Registriervorrichtungen, Registrierstifte oder Schablonen minimiert. Die Registriervorrichtungen, Registrierstifte oder Schablonen bestehen vorzugsweise aus einem Material, ausgewählt aus der Gruppe, umfassend Graphit, Keramik und Metall, deren Oberfläche mit einer entsprechenden Schutzschicht, vorzugsweise einer Keramikschutzschicht, überzogen wird. Die Höhe der Registriervorrichtungen, Registrierstifte oder Schablonen sollte dabei niedriger sein als der Stapel der Folien. Es können aber auch entsprechende Vertiefungen in den Basis- und Deckplatten vorgesehen sein, was dann den Vorteil einer beidseitigen Registrierung (von oben und unten) bieten kann. Bei Verwendung von Mehrfachnutzen kann vorzugsweise mit metallischen oder nicht metallischen Registrierstiften gearbeitet werden. Hierzu werden im Strukturierungsprozess im Randbereich des Nutzens entsprechende Aussparungen vorgesehen, in die Registrierstifte eingeführt werden können, so dass mit minimaler Toleranz ein geringer Versatz in den Bauteilen sichergestellt werden kann. Auch hier besitzen die Registrierstifte vorzugsweise eine geringere Höhe als das Gesamtbauteil. Die Nutzen können aber beispielsweise auch Strukturmerkmale, bevorzugt im Randbereich der Bauteillagen, besitzen, die eine Selbstregistrierung ermöglichen, z.B. geprägte, geätzte oder gestanzte Vertiefungen, die beim Stapeln den Versatz der einzelnen Lagen verhindert. Aus dem Mehrfachnutzen werden die Bauteillagen nach dem Lötprozess z.B. durch Schneiden, Fräsen, Stanzen, Lasern vereinzelt. Auf die Nutzen oder die in den Registriervorrichtungen gestapelten Folien wird ebenfalls eine Graphitplatte und Keramikfaserpapier gelegt, die den Abschluss zur oberen Anpressplatte bilden.

Der Stapel lotbeschichteter und/oder mikrostrukturierter Bauteillagen (Bleche oder Mehrfachnutzen) wird dann unter Einwirkung von Wärme- und Anpressdruck im Vakuum oder in Inertgasatmosphäre verlötet. Bevorzugte Bedingungen für den Lötprozess sind Löttemperaturen von 100 - 600°C und ein Druck, unter dem der Stapel verpresst wird, von mindestens 0,1 MPa, insbesondere mindestens 0,5 MPa. Weitere wichtige Parameter für den Lötprozess sind der Druck in der Fügeapparatur, die Aufheizrate, Haltedauer der Temperatur (Temperungszeit) und die Abkühlzeit. Die drei letztgenannten Parameter sowie die Dicke der einzelnen Lotteilschichten und der Anpressdruck können insbesondere zur Steuerung der intermetallischen Phasenbildung in der Lotnaht eingestellt werden. Durch längere Aufheiz- und Abkühlphasen sowie höhere Temperungszeiten können die Elemente der Lotteilschichten stärker ineinander diffundieren. Durch Wahl der Temperungszeit kann andererseits auch die Art und Menge der intermetallischen Phasen gesteuert werden, die sich in der Lotnaht bilden. Die Art der intermetallischen Phasen hängt natürlich insbesondere von der Art der Metalle der Lotschicht ab. In einer bevorzugten Ausführungsform der Erfindung werden die Bauteillagen durch mindestens ein schnelles Verfahren, ausgewählt aus der Gruppe, umfassend Aufheizen und Abkühlen, miteinander verbunden. Unter schnellen Aufheiz- und Abkühlverfahren werden Verfahren verstanden, bei denen die Geschwindigkeit im Bereich oberhalb von 5 grad/min liegt.

Um einen gleichmäßigen, vollflächigen Verbund der einzelnen Bleche untereinander zu erreichen, muss ein Mindestdruck als Funktion der Temperatur und der Schichtdicke der Lotschicht bzw. der Lotteilschichten homogen verteilt auf den zu verlötenden Stapel ausgeübt werden. Neben der Verbesserung des Kontaktes der zu verlötenden Flächen und der damit verbundenen Beschleunigung der Interdiffusion und der Bildung der intermetallischen Phasen kann die Sprödphasenbildung und -verteilung durch den Anpressdruck günstig beeinflusst oder ganz vermieden werden. Die Vermeidung bzw. Verteilung der Sprödphasen ist für die spätere Festigkeit und Korrosionsbeständigkeit mitentscheidend. Anpressdrücke von weniger als 0,1 MPa während des Lötprozesses ergeben nur unzureichende Festigkeiten und Druckstabilitäten.

Je nach Zusammensetzung der Lotschicht liegt die Löttemperatur im Bereich von 100 - 600°C. Die Aufheizrate muss so gewählt werden, dass einerseits die Barriereschicht zur ausreichenden Haftvermittlung mit dem Grundmaterial reagieren kann. Andererseits darf die Interdiffusion der Lotkomponenten während des Aufheizens in die übrigen Schichten nicht zu einer Verarmung der schmelzflüssigen Phase führen mit der Folge, dass eine ausreichende Festigkeit des Verbundes nicht erreicht würde.

### Nachfolgende Figur und die Beispiele dienen zur Erläuterung der Erfindung:

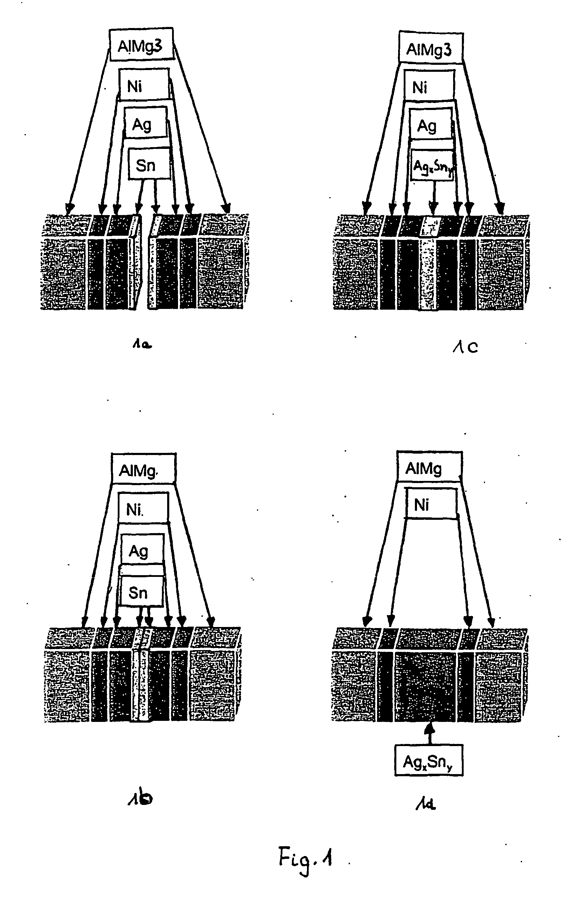

**Fig. 1** zeigt in schematischer Form die Bildung einer multifunktionellen Barriereschicht sowie intermetallischer Phasen aus den Lotteilschichten auf einem Grundmaterial in vier Teilschritten (**Fig. 1a** bis **1d**).

### Beispiel 1:

0,3 mm dicke AlMg3-Bleche wurden mit Strömungskanälen versehen, indem ein Strömungskanalmuster mittels Fotolithografie auf den Blechen abgebildet wurde und die Kanäle anschließend durch Tiefenätzen gebildet wurden.

Bevor funktionale Schichten auf die Wände der Strömungskanäle aufgebracht wurden, wurden die Bleche gereinigt und vorbehandelt. Hierzu wurden die Bleche, inklusive Deck- und Bodenbleche,
1. entfettet (Netzmittel enthaltende alkalische Lösung; Uniclean® 155, 3 Gew.-%, Atotech Deutschland GmbH)
   1 a. gespült
2. gebeizt (saure Beize; AlumEtchS®, Atotech Deutschland GmbH)
   2a. gespült
3. mit einer Zinkatbeize behandelt (stark alkalische Lösung von Zinkhydroxid; AlumSeal650®, Atotech Deutschland GmbH)
   3a. gespült
   Die Vorbehandlungsschritte 2, 2a, 3 und 3a wurden zweimal hintereinander durchgeführt.
   Nachdem die Zinkatschicht homogen gebildet worden war, wurden die Barriereschicht und die Lotschicht abgeschieden. Hierzu wurde zuerst
4. Nickel abgeschieden (stromlos oder elektrolytisch), Dicke 5 µm (Nickelsulfamatbad von Atotech Deutschland GmbH)
   4a. gespült
   Die Nickelschicht diente als multifunktionale Barriereschicht. Anschließend wurde aus einem silberkomplexhaltigen Elektrolyten eine dünne Schicht Silber auf der Barriereschicht abgeschieden. Hierzu wurde
5. Vor-Silber abgeschieden (elektrolytisch), Dicke < 1 µm (Silber-Trisalyt®, Atotech Deutschland GmbH)
   5a. gespült
   Danach wurde die Lotschicht gebildet. Hierzu wurde zuerst
6. Silber abgeschieden (elektrolytisch), Dicke 7 µm (AgO-56®, Atotech Deutschland GmbH)
   6a. gespült
   Silber diente als hochschmelzende Lotteilschicht. Danach wurde die niedrigschmelzende Lotteilschicht abgeschieden. Hierzu wurde
7. Zinn abgeschieden (elektrolytisch), Dicke 2,5 µm (Sulfotech TM, Atotech Deutschland GmbH)
   7a. gespült
   7b. getrocknet.

Die Bleche wurden jeweils mit deionisiertem Wasser gespült. Die beschichteten Bleche wurden in einer Laminierpresse entweder einzeln oder vorzugsweise im Mehrfachnutzen gestapelt. Mit einer Aufheizrate von 7 K/min wurde eine Löttemperatur von 330°C angesteuert. Die Löttemperatur wurde nach Erreichen 30 min lang gehalten. Nach 30 min wurde der Stapel nicht aktiv abgekühlt. Die Dauer der Abkühlphase betrug 90 min. Während des gesamten Lötprozesses wurde ein Druck von 4,5 MPa auf den Stapel ausgeübt.

In **Fig. 1** sind die Schichtfolgen auf dem Grundmaterial in den einzelnen Phasen des Herstellungsprozesses schematisch wiedergegeben:

In **Fig. 1a** ist zu erkennen, dass auf dem Aluminium-Grundmaterial eine Barriereschicht aus Ni, darauf jeweils eine hochschmelzende Lotteilschicht aus Silber und abschließend darauf jeweils eine niedrigschmelzende Lotteilschicht aus Zinn gebildet worden ist. In **Fig. 1b** ist die Bildung des Stapels vor dem Beginn des Lötprozesses schematisch angedeutet. Die einzelnen Schichten sind noch vorhanden. In **Fig. 1c** ist der Fortgang der Interdiffusion der Lotteilschichten ineinander erkennbar: Während die Barriereschichten auf den Aluminium-Grundmaterialien vollständig vorhanden sind, hat bereits eine partielle Interdiffusion der Lotteilschichten unter Bildung einer mittleren intermetallischen AgxSny-Phase begonnen. Ein Teil der hochschmelzenden und der niedrigschmelzenden Lotteilschichten ist noch vorhanden. In **Fig. 1d** ist der Abschluss der Interdiffusion nach Durchführung des Lötprozesses schematisch gezeigt: Die beiden Lotteilschichten sind durch Diffusion vollständig verschwunden.

Die stöchiometrische Zusammensetzung der einzelnen Schichten wurde mit REM/EDX (Rasterelektronenmikroskopie/energiedispersive Röntgenfluoreszenz) bestimmt und entsprach überwiegend der intermetallischen Phase Ag₅Sn (ζ-Phase).

### Beispiel 2:

0,3 mm dicke Cu-Bleche wurden mit Strömungskanälen versehen, indem ein Strömungskanalmuster mittels Fotolithografie auf den Blechen abgebildet wurde und die Kanäle anschließend durch Tiefenätzen gebildet wurden. Bevor funktionale Schichten auf die Wände der Strömungskanäle aufgebracht wurden, wurden die Bleche gereinigt und vorbehandelt. Hierzu wurden die Bleche, inklusive Deck- und Bodenbleche,
1. entfettet (Netzmittel enthaltende alkalische Lösung; Uniclean® 155, 3 Gew.-%, Atotech Deutschland GmbH)
   1 a. gespült
2. dekapiert (sauer, Uniclean® 675, Atotech Deutschland GmbH)
   2a. gespült
3. elektrolytisch entfettet (alkalisch, Uniclean® 279, Atotech Deutschland GmbH)
   3a. gespült
4. mikrogeätzt (Dekapierung, sauer; Uniclean® 697, Atotech Deutschland GmbH)
   4a. gespült
   Anschließend wurden die Barriereschicht und die Lotschicht abgeschieden. Hierzu wurde zuerst
5. Nickel abgeschieden (stromlos oder elektrolytisch), Dicke 5 µm (Nickelsulfamat-Bad, Atotech Deutschland GmbH)
   5a. gespült
   Die Nickelschicht diente als multifunktionale Barriereschicht. Anschließend wurde aus einem silberkomplexhaltigen Elektrolyten eine dünne Schicht Silber auf der Barriereschicht abgeschieden. Hierzu wurde
6. Vor-Silber abgeschieden (elektrolytisch), Dicke < 1 µm (Silber-Trisalyt®, Atotech Deutschland GmbH)
   6a. gespült
   Danach wurde die Lotschicht gebildet. Hierzu wurde zuerst
7. Silber abgeschieden (elektrolytisch), Dicke 10 µm (AgO-56®, Atotech Deutschland GmbH)
   7a. gespült
   Silber diente als hochschmelzende Lotteilschicht. Danach wurde die niedrigschmelzende Lotteilschicht abgeschieden. Hierzu wurde
8. Zinn abgeschieden (elektrolytisch), Dicke 3 µm (Sulfotech TM, Atotech Deutschland GmbH)
   8a. gespült
   8b. getrocknet.

Die Bleche wurden jeweils mit deionisiertem Wasser gespült.

Die beschichteten Bleche wurden in einer Laminierpresse entweder einzeln oder vorzugsweise im Mehrfachnutzen gestapelt. Nachfolgend wurde folgende Versuchsreihe zur Herstellung von Bauteilen mit gleichem Design jedoch unterschiedlichen Qualitätsmerkmalen durchgeführt:
a. Mit einer Aufheizrate von 7 K/min wurde eine Löttemperatur von 250°C angesteuert und nach Erreichen der Löttemperatur ohne Haltezeit wieder abgekühlt. Der Stapel wurde nicht aktiv abgekühlt. Die Dauer der Abkühlphase betrug ca. 60 min. Während des gesamten Lötprozesses wurde ein Druck von 4,5 MPa auf den Stapel ausgeübt. Die Bauteile zeigten Druckstabilitäten minderer Qualität und eine sehr hohe Ausschussrate (80%). Die Bauteile wurden bei dem in diesem Beispiel verwendeten Design und einer Bodenplattendicke von 1 mm bei einem Innendruck im Bereich von 0 bis 2 bar undicht. Die Zusammensetzung der Lotnaht wurde mit REM/EDX bestimmt und ergab, dass die hochschmelzende und die niedrigschmelzende Lotteilschicht noch zum allergrößten Teil in Reinform vorhanden waren.
b. Mit einer Aufheizrate von 7 K/min wurde eine Löttemperatur von 250°C angesteuert. Die Löttemperatur wurde nach Erreichen 30 min lang gehalten. Der Stapel wurde nicht aktiv abgekühlt. Die Dauer der Abkühlphase betrug ca. 60 min. Während des gesamten Lötprozesses wurde ein Druck von 4,5 MPa auf den Stapel ausgeübt. Die Bauteile wurden mit identischem Design wie in Versuch a. und einer Bodenplattendicke von 1 mm bei einem Innendruck im Bereich von 10 bis 15 bar undicht. Die Zusammensetzung der Lotnaht wurde mit REM/EDX bestimmt und ergab, dass neben der hochschmelzenden und der niedrigschmelzenden Lotteilschicht die Phase der Zusammensetzung Ag₃Sn (ε-Phase) gebildet wurde.
c. Bauteile, die nach Versuch a. verlötet wurden, wurden in einem Ofen 30 min lang bei einer Temperatur von 330°C thermisch nachbehandelt, ohne dass Druck auf die Bauteile ausgeübt wurde. Die Bauteile wurden im anschließenden Bersttest bei einem Innendruck von etwa 30 bar undicht. Die Zusammensetzung der Lotnaht wurde mit REM/EDX bestimmt und ergab, dass neben der hochschmelzenden und der niedrigschmelzenden Lotteilschicht die Phase der Zusammensetzung Ag₃Sn (ε-Phase) sowie die Phase der Zusammensetzung Ag₅Sn (ζ-Phase) gebildet wurde.
d. Mit einer Aufheizrate von 7 K/min wurde eine Löttemperatur von 330°C angesteuert und nach Erreichen der Löttemperatur ohne Haltezeit wieder abgekühlt. Der Stapel wurde nicht aktiv abgekühlt. Die Dauer der Abkühlphase betrug ca. 90 min. Während des gesamten Lötprozesses wurde ein Druck von 4,5 MPa auf den Stapel ausgeübt. Die Bauteile wurden mit identischem Design wie in Versuch a. und einer Bodenplattendicke von 1 mm im anschließenden Bersttest bei einem Innendruck im Bereich von 5 bis 10 bar undicht. Die Zusammensetzung der Lotnaht wurde mit REM/EDX bestimmt und ergab, dass neben der hochschmelzenden und der niedrigschmelzenden Lotteilschicht die Phase der Zusammensetzung Ag₃Sn (ε-Phase) gebildet worden war.
e. Bauteile, die nach Versuch c. verlötet worden waren, wurden in einem Ofen 30 min lang bei einer Temperatur von 330°C thermisch nachbehandelt, ohne dass Druck auf die Bauteile ausgeübt wurde. Die Bauteile wurden im anschließenden Bersttest bei einem Innendruck im Bereich von 35 bis 40 bar undicht. Die Zusammensetzung der Lotnaht wurde mit REM/EDX bestimmt. Die Analyse ergab, dass neben der hochschmelzenden und der niedrigschmelzenden Lotteilschicht die Phase der Zusammensetzung Ag₃Sn (ε-Phase) sowie die Phase der Zusammensetzung Ag₅Sn (ζ-Phase) gebildet worden war.
f. Bauteile, die nach Versuch c. verlötet worden waren, wurden in einem Ofen 30 min lang bei einer Temperatur von 330°C thermisch nachbehandelt, wobei während der gesamten Temperungsdauer ein Druck von 4,5 MPa auf die Bauteile ausgeübt wurde. Die Bauteile blieben im anschließenden Bersttest bis zu einem Innendruck von 60 bar dicht. Die Zusammensetzung der Lotnaht wurde mit REM/EDX bestimmt. Die Analyse ergab, dass die Phasen der Zusammensetzung Ag₃Sn (ε-Phase) sowie überwiegend der Zusammensetzung Ag₅Sn (ζ-Phase) gebildet wurden.

Die Ergebnisse zeigen den qualitativen Zusammenhang zwischen Löttemperatur, Lötdauer und Anpressdruck mit der Berstfestigkeit der Mikrostrukturbauteile. Die Absolutwerte der Berstdrucke sind von dem gewählten Design und der Dicke der Bodenplatte stark abhängig und können daher nur zwischen Bauteilen identischen Designs unter gleichen Bedingungen verglichen werden. Insgesamt zeigen die Versuche aber, dass z.B. die Prozesszeit bei einer Temperatur von 330°C erheblich verkürzt und die Berstfestigkeit durch einen nachträglichen Temperungsschritt ohne zusätzlichen Anpressdruck erheblich erhöht werden konnte.

Diese Erhöhung der Berstfestigkeit ist beispielhaft unmittelbar an die verstärkte Ausbildung der silberreicheren intermetallischen Phase und der festen Lösung geknüpft. Eine weitere Steigerung der Berstfestigkeit ist durch Erhöhung der Silberschichtdicke, der Haltedauer, der Prozesstemperatur(en) und des Anpressdruckes zu erzielen.

Durch das hier beschriebene Verfahren lassen sich die Produkteigenschaften als Funktion der Prozesskosten gezielt steuern.

Mit den nachfolgend beschriebenen Figuren wird die Erfindung noch näher erläutert. Es zeigen im einzelnen:
- **Fig. 2a:**: eine schematische Darstellung eines Lötaufbaus mit Mikrostrukturbauteilen im Querschnitt;
- **Fig. 2b:**: eine schematische Darstellung eines Lötaufbaus mit Mikrostrukturbauteilen in der Draufsicht;
- **Fig. 3:**: eine schematische Darstellung einer Schablone zur Registrierung von Mikrostrukturbauteilen im Querschnitt in Seitenansicht;
- **Fig. 4:**: eine schematische Darstellung einer Bauteilhalterung mit Mikrostrukturbauteilen in der Draufsicht;
- **Fig. 5:**: eine schematische Darstellung einer Schablone in einer ersten Ausführungsform in der Draufsicht;
- **Fig. 6a:**: eine schematische Darstellung einer Schablone in einer zweiten Ausführungsform in der Draufsicht;
- **Fig. 6b:**: eine schematische Darstellung eines Details aus **Fig. 6a**;
- **Fig. 7:**: eine schematische Darstellung eines Mehrfachnutzens mit Registrierbohrungen in der Draufsicht;
- **Fig. 8a:**: eine schematische Darstellung eines Lötaufbaus zum Löten von Mehrfachnutzen im Querschnitt;
- **Fig. 8b:**: eine schematische Darstellung entsprechend **Fig.7a**.

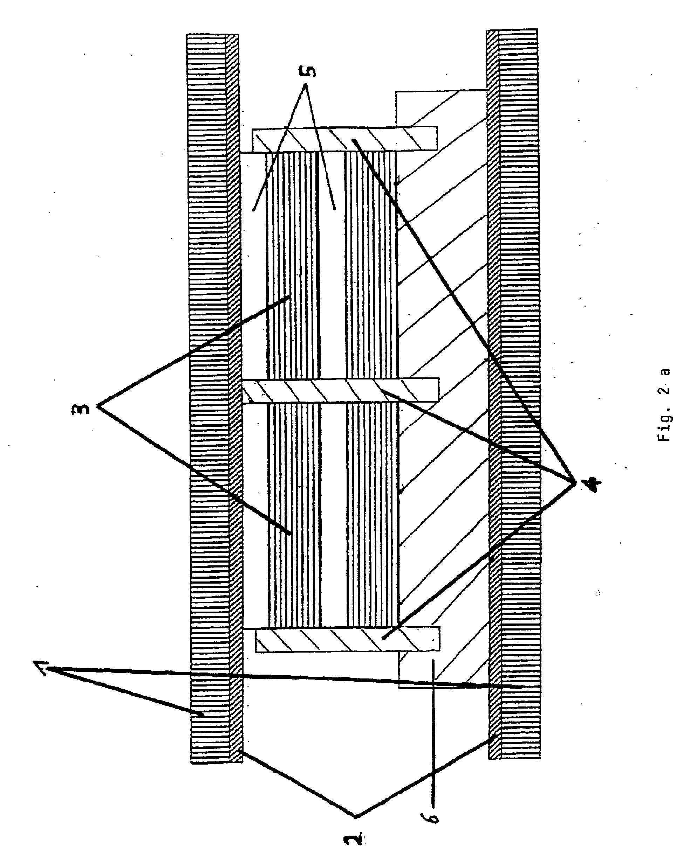

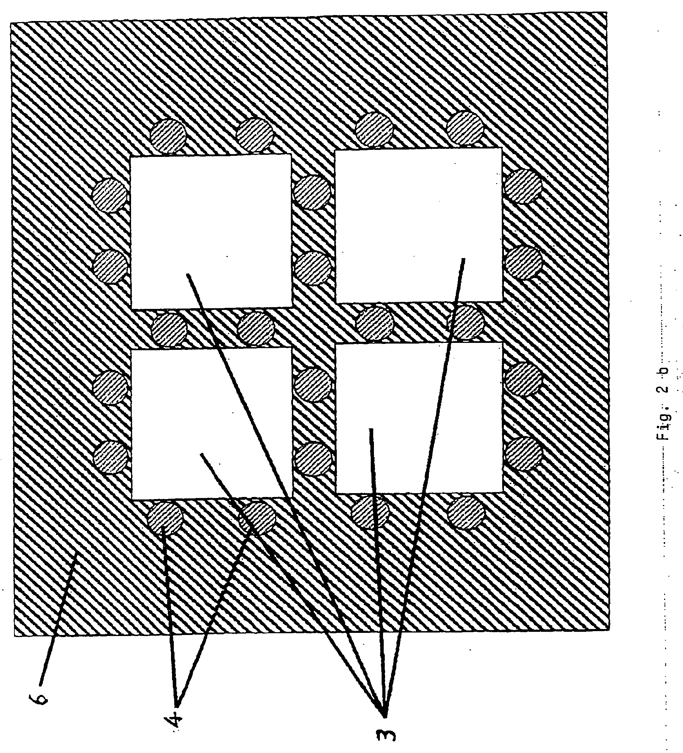

In **Fig. 2a** ist ein Lötaufbau mit Mikrostrukturbauteilen **3** im Querschnitt dargestellt. Die Mikrobauteile **3** werden über in der Bodenplatte **6** montierte Registrierstifte **4** registriert. Druck wird über Presswerkzeuge **1** aufgebracht, wobei die Presspolster **2** zum Höhenausgleich zwischen den einzelnen Mikrobauteilen **3** dienen und somit eine homogene Druckverteilung ermöglichen. In **Fig. 2b** ist der Lötaufbau in Draufsicht schematisch gezeigt. Es ist zu erkennen, dass die Registrierstifte **4** auf der Bodenplatte **6** montiert sind. Die Mikrobauteile sind mit der Bezugsziffer **3** bezeichnet.

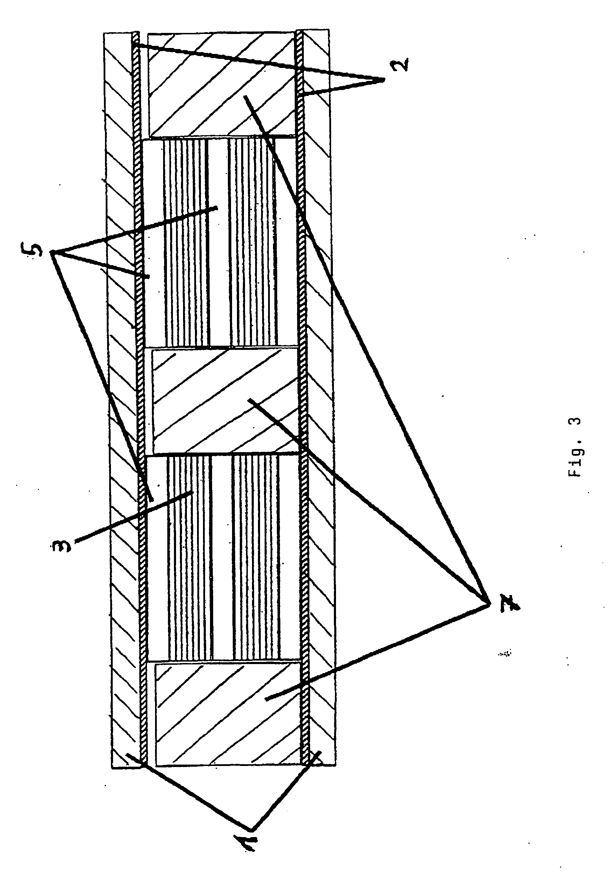

**Fig. 3** zeigt eine schematische Darstellung einer Schablone **7** zur Registrierung von Mikrostrukturbauteilen **3** im Querschnitt in Seitenansicht. Die Mikrostrukturbauteile **3** sind in der Schablone **7** durch Zwischenplatten **5** voneinander getrennt. Druck wird über Presswerkzeuge **1** aufgebracht, wobei die Presspolster **2** zum Höhenausgleich zwischen den einzelnen Mikrobauteilen **3** dienen und somit eine homogene Druckverteilung ermöglichen.

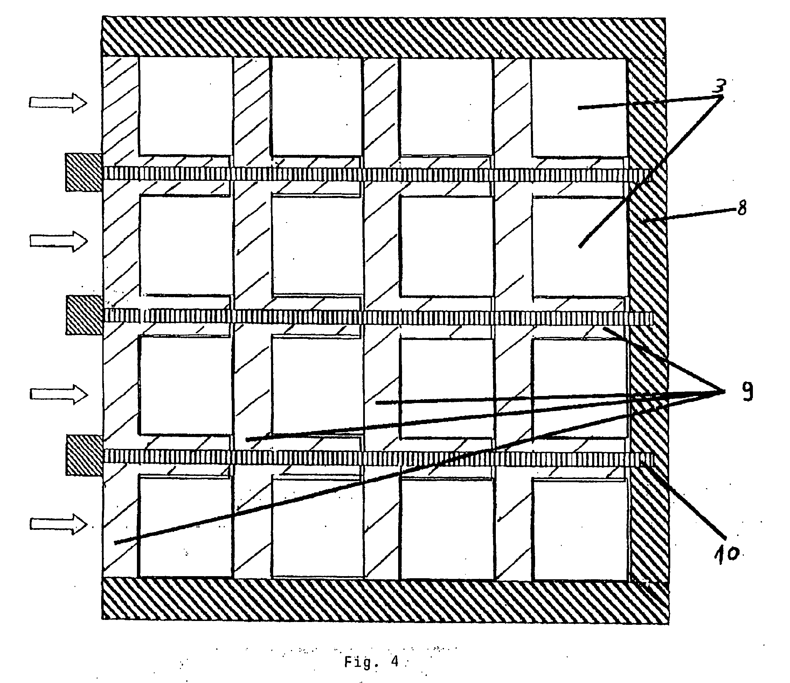

**Fig. 4** zeigt eine Bauteilhalterung mit Mikrostrukturbauteilen **3** in einer Draufsicht in schematischer Darstellung. Die Mikrostrukturbauteile **3** werden über verstellbare Registriervorrichtungen **9** registriert, die über eine Spannvorrichtung **10** bewegt wird. Ein Rahmen **8** dient zur Führung der Registriervorrichtungen **9** und zur Kraftaufnahme der Spannvorrichtung **10**. Die Pfeile deuten die Richtung an, in der durch die Registriervorrichtungen **9** und die Spannvorrichtung **10** zur Registrierung eine Spannkraft auf die Mikrostrukturbauteile **3** ausgeübt werden kann.

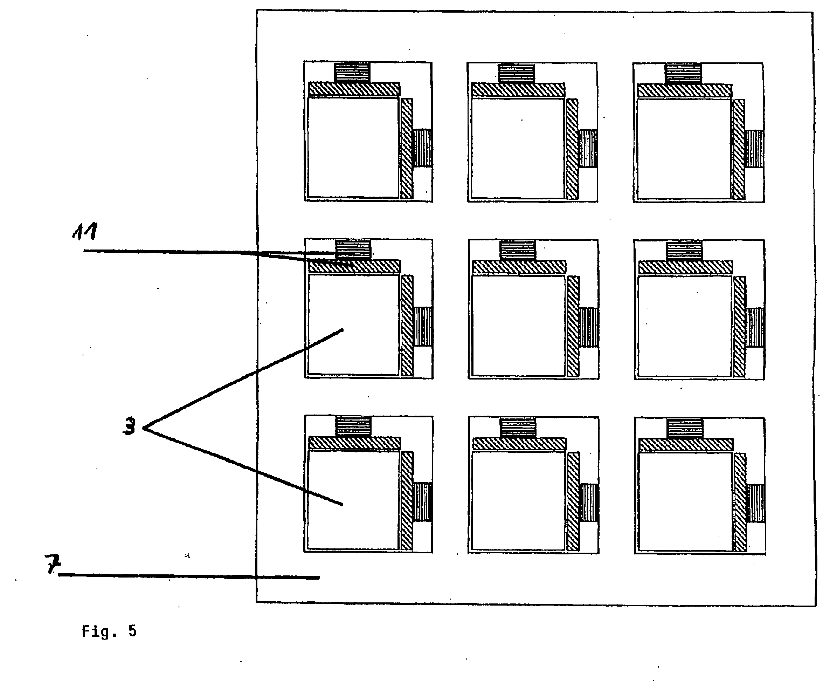

In Fig. **5** ist eine Schablone **7** in der Draufsicht schematisch dargestellt. Die Mikrostrukturbauteile **3** werden über eine seitliche Anpressplatte mit Feder **11** registriert. Die Mikrostrukturbauteile **3** werden dabei von zwei Seiten an die Schablonenwandung in der Schablone **7** geschoben.

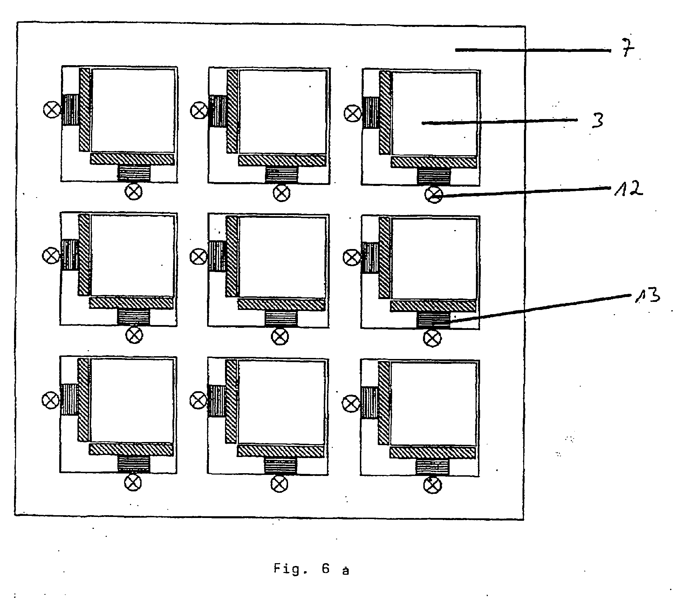

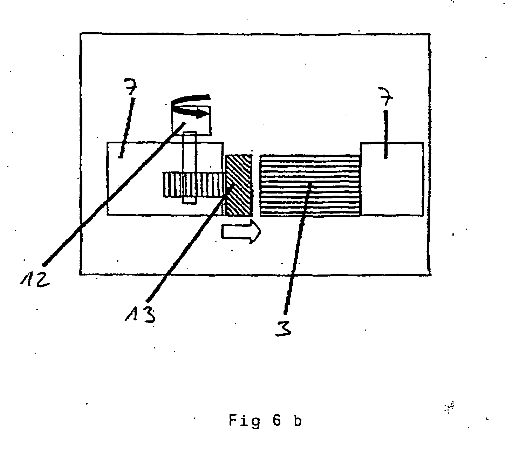

In **Fig. 6a** ist eine Schablone **7** in der Draufsicht schematisch dargestellt. Die Mikrostrukturbauteile **3** werden mittels einer Anpressplatte mit Registrierschraube **13** registriert, die über eine Justierschraube **12** bewegt wird. Dabei werden die Mikrostrukturbauteile **3** von zwei Seiten an die Schablonenwandung der Schablone **7** geschoben. Die Justiervorrichtung ist in **Fig. 6b** vergrößert gezeigt. Dort ist die Registrierschraube **13** mit der Justierschraube **12** (Drehrichtung angegeben durch geschlossenen Pfeil) detailliert wiedergegeben. Das dort dargestellte Mikrostrukturbauteil **3** wird in Richtung des offenen Pfeils gegen die gegenüberliegende Wand der Schablone **7** gedrückt, um die einzelnen Bauteillagen gegeneinander zu justieren.

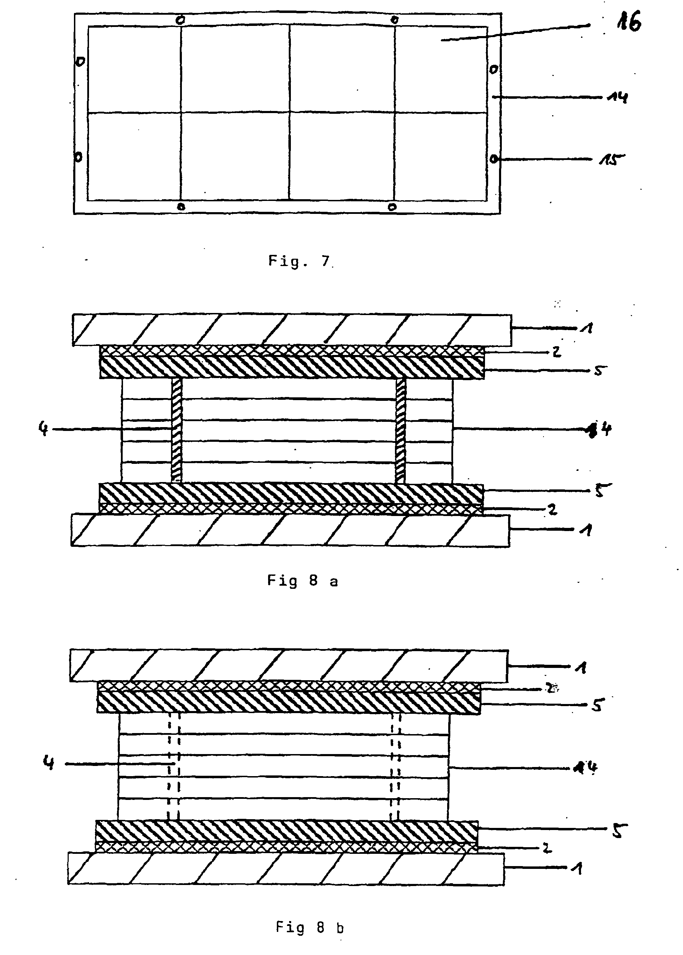

In **Fig. 7** ist ein Mehrfachnutzen **14** mit Registrierbohrungen **15** in der Draufsicht schematisch wiedergegeben; Der Mehrfachnutzen **14** besteht aus mehreren Mikrostrukturblechen **16,** die zur Herstellung von Mikrostrukturbauteilen eingesetzt werden. Die Mikrostrukturbleche **16** werden in diesem Fall nach der Lötung vereinzelt.

In **Fig. 8a** ist ein Lötaufbau zum Löten von Mehrfachnutzen **14** im Querschnitt in Seitenansicht schematisch dargestellt. Die Mehrfachnutzen **14** werden durch außen angebrachte Registrierstifte **4** registriert, die mit den Zwischenplatten **5** verbunden sind. Der Fügedruck wird über das Presswerkzeug **1** eingebracht. Eine homogene Druckverteilung wird durch Presspolster **2** gewährleistet. In **Fig. 8b** ist eine schematische Darstellung entsprechend **Fig. 8a** wiedergegeben. Die Mehrfachnutzen **14** werden durch Registrierstifte **4** registriert, die durch die in **Fig. 7** gezeigten Registrierbohrungen **15** im Mehrfachnutzen **14** geführt werden.

### Bezugszeichenliste

- **1**: Presswerkzeug
- **2**: Presspolster
- **3**: Mikrostrukturbauteile
- **4**: Registrierstifte
- **5**: Zwischenplatten
- **6**: Bodenplatte
- **7**: Schablone
- **8**: Rahmen
- **9**: Verstellbare Registriervorrichtung
- **10**: Spannvorrichtung
- **11**: Anpressplatte mit Feder
- **12**: Justierschraube
- **13**: Anpressplatte mit Registrierschraube
- **14**: Mehrfachnutzen
- **15**: Registrierbohrung
- **16**: Mikrostrukturbleche

## Patentansprüche

1. Verfahren zum Verbinden von zur Herstellung von Mikroreaktoren, Mikromischern und Mikrowärmeaustauschern (3) geeigneten, aus Stoffen, ausgewählt aus der Gruppe, umfassend Metalle und Metalllegierungen, bestehenden mikrostrukturierten Bauteillagen (16), die Bauteillagen (16) gestapelt und dann unter Wärmeeinwirkung gelötet werden, **dadurch gekennzeichnet, dass** mindestens auf Fügeflächen der Bauteillagen (16) mindestens eine multifunktionelle Barriereschicht und auf die mindestens eine Barriereschicht eine Lotschicht aufgebracht werden und daß die multifunktionelle Barriereschicht aus mindestens einem Metall besteht, ausgewählt aus der Gruppe, bestehend aus Molybdän, Mangan, Chrom, Palladium, Eisen, Nickel und Legierungen mindestens eines Metalls, ausgewählt aus der Gruppe, umfassend Eisen und Nickel, mit Phosphor.

2. Verfahren nach Anspruch 1, **dadurch gekennzeichnet, dass** die Stoffe ausgewählt sind aus der Gruppe, umfassend Aluminium, Aluminiumlegierungen, Kupfer, Kupferlegierungen und Edelstähle.

3. Verfahren nach einem der vorstehenden Ansprüche, **dadurch gekennzeichnet, dass** das Lötverfahren ein Schmetzdiffusionsiötverfahren ist.

4. Verfahren nach einem der vorstehenden Ansprüche, **dadurch gekennzeichnet, dass** das Lötverfahren ohne Flussmittel durchgeführt wird.

5. Verfahren nach einem der vorstehenden Ansprüche, **dadurch gekennzeichnet, dass** zur Bildung der Lotschicht mindestens eine Lotteilschicht aufgebracht wird.

6. Verfahren nach einem der vorstehenden Ansprüche, **dadurch gekennzeichnet, dass** zur Bildung der Lotschicht zwei Lotteilschichten aufgebracht werden.

7. Verfahren nach einem der Ansprüche 5 und 6, **dadurch gekennzeichnet, dass** die Lotteilschichten mindestens eine hochschmelzende und mindestens eine niedrigschmelzende Lotteilschicht sind.

8. Verfahren nach Anspruch 7, **dadurch gekennzeichnet, dass** die mindestens eine hochschmelzende Lotteilschicht aus mindestens einem Metall, ausgewählt aus der Gruppe, umfassend Silber, Gold, Nickel und Kupfer, gebildet wird.

9. Verfahren nach einem der Ansprüche 7 und 8, **dadurch gekennzeichnet, dass** die mindestens eine niedrigschmelzende Lotteilschicht aus mindestens einem Metall, ausgewählt aus der Gruppe, umfassend Zinn, Indium und Wismut, gebildet wird.

10. Verfahren nach einem der Ansprüche 7-9, **dadurch gekennzeichnet, dass** zuerst die mindestens eine hochschmelzende Lotteilschicht und dann die mindestens eine niedrigschmelzende Lotteilschicht auf die Bauteillagen abgeschieden wird.

11. Verfahren nach einem der Ansprüche 5 - 10, **dadurch gekennzeichnet, dass** die Zusammensetzung und Dicke der Lotteilschichten so gewählt werden, dass sich beim Löten ein initiales Eutektikum bilden kann.

12. Verfahren nach einem der vorstehenden Ansprüche, **dadurch gekennzeichnet, dass** die Bauteillagen (16) durch isothermes Löten miteinander verbunden werden.

13. Verfahren nach einem der vorstehenden Ansprüche, **dadurch gekennzeichnet, dass** die Bauteillagen (16) durch gleichzeitige Anwendung von Wärme und Anpressdruck miteinander verbunden werden.

14. Verfahren nach einem der vorstehenden Ansprüche, **dadurch gekennzeichnet, dass** die Bauteillagen (16) durch mindestens ein schnelles Verfahren ausgewählt aus der Gruppe, umfassend Aufheizen und Abkühlen, miteinander verbunden werden.

15. Verfahren nach einem der vorstehenden Ansprüche, **dadurch gekennzeichnet, dass** bei einer Temperatur im Bereich von 100 bis 600°C, einem Druck, unter dem der Stapel verpresst wird, von mindestens 0,1 MPa, mit einer Haltezeit im Bereich von 0 bis 60 min gelötet und mit einer Temperungszeit im Bereich von 0 bis 60 min temperaturbehandelt wird.

16. Verfahren nach einem der vorstehenden Ansprüche, **dadurch gekennzeichnet, dass** mindestens eine Schicht, ausgewählt aus der Gruppe, umfassend multifunktionale Barrieresehichten, hochschmelzende Lotteilschichten und niedrigschmelzende Lotteilschichten, mittels galvanotechnischer Methoden gebildet werden.

17. Verfahren nach einem der vorstehenden Ansprüche, **dadurch gekennzeichnet, dass** die Bauteillagen (16) im Mehrfachnutzen gelötet werden.

18. Verfahren nach einem der vorstehenden Ansprüche, **dadurch gekennzeichnet, dass** die Bauteillagen (16) in einer Leiterplatten-Laminierpresse gelötet werden.

19. Verfahren nach einem der vorstehenden Ansprüche, **dadurch gekennzeichnet, dass** beim Löten Werkstoffplatten oder-lagen oder follen aus einem Material, ausgewählt aus der Gruppe, umfassend Metalle, Keramiken, Graphit und Verbundwerkstoffe, als Presswerkzeuge (1) verwendet werden.

20. Verfahren nach einem der vorstehenden Ansprüche, **dadurch gekennzeichnet dass** beim Löten Keramikvliese als Presspolster (2) verwendet werden.

21. Verfahren nach einem der vorstehenden Ansprüche, **dadurch gekennzeichnet, dass** beim Löten Registriervorrichtungen (9), Registrierstifte (4) oder Schabionen (7) zur Registrierung verwendet werden.

22. Verfahren nach Anspruch 21, **dadurch gekennzeichnet, dass** die Registriervorrichtungen (9), Registrierstifte (4) oder Schablonen (7) aus einem Material bestehen, ausgewählt aus der Gruppe, umfassend Graphit, Keramik und Metall.

23. Verfahren nach einem der vorstehenden Ansprüche, **dadurch gekennzeichnet, dass** beim Löten Strukturmerkmale der Bauteillagen (16) zur Selbstregistrierung verwendet werden.

24. Verfahren nach einem der vorstehenden Ansprüche, **dadurch gekennzeichnet, dass** die Bauteillagen (16) nach dem Lötprozess durch Schneiden, Fräsen, Stanzen oder Lasern vereinzelt werden.

25. Mikrostrukturbauteil (3), ausgewählt aus der Gruppe, bestehend aus Mikroreaktoren, Mikromischern und Mikrowärmeaustauschern, umfassend einen Stapel von miteinander verbundenen, aus Stoffen, ausgewählt aus der Gruppe, umfassend Metalle und Metalllegierungen, bestehenden mikrostrukturierten Bauteillagen (16), **dadurch gekennzeichnet, dass** mindestens eine multifunktionelle Barriereschicht sowie eine Lotschicht zwischen den einzetnen Bauteillagen (16) aufweist, und daß die multifunktionelle Barriereschicht aus mindestens einem Metall besteht, ausgewählt aus der Gruppe, bestehend aus Molybdän, Mangan, Chrom, Palladium, Eisen, Nickel und Legierungen mindestens eines Metalls, ausgewählt aus der Gruppe, umfassend Eisen und Nickel, mit Phosphor.

26. Mikrostrukturbauteil nach Anspruch 25, **dadurch gekennzeichnet, dass** die Stoffe ausgewählt sind aus der Gruppe, umfassend Aluminium, Aluminiumlegierungen, Kupfer, Kupferlegierungen und Edelstähte.

27. Mikrostrukturbauteil nach einem der Ansprüche 25 und 26, **dadurch gekennzeichnet, dass** die Bauteillagen (16) durch ein Schmelzdiffusionslötverfahren miteinander verbunden sind.

28. Mikrostrukturbauteil nach einem der Ansprüche 25 - 27, **dadurch gekennzelchnet, dass** die Lotschicht aus mindestens einem hochschmelzenden und mindestens einem niedrigschmelzenden Metall besteht.

29. Mikrostrukturbauteil nach Anspruch 28, **dadurch gekennzeichnet, dass** das mindestens eine hochschmelzende Metall ausgewählt ist aus der Gruppe, umfassend Gold, Silber, Nickel und Kupfer.

30. Milsrgstrukturbauteil nach einem der Ansprüche 28 und 29, **dadurch gekennzeichnet, dass** das mindestens eine niedrigschmelzende Metall ausgewählt ist aus der Gruppe, umfassend Zinn. Indium und Wismut.

31. Mikrostrukturbauteil nach einem der Ansprüche 25 - 30, **dadurch gekennzeichnet, dass** die Bauteillagen (16) im Mehrfachnutzen gelötet sind.

## Claims

1. Method for connecting microstructured component layers (16) which are suitable for producing microreactors, micromixers and micro-heat exchangers (3) and comprise materials selected from the group including metals and metal alloys, the component layers (16) are stacked and then soldered under the effect of heat, **characterised in that** at least one multifunctional barrier layer is applied at least on joint faces of the component layers (16), and a solder layer is applied on the at least one barrier layer, and **in that** the multifunctional barrier layer comprises at least one metal selected from the group comprising molybdenum, manganese, chromium, palladium, iron, nickel and alloys of at least one metal selected from the group comprising iron and nickel with phosphorus.

2. Method according to claim 1, **characterised in that** the materials are selected from the group comprising aluminium, aluminium alloys, copper, copper alloys and stainless steels.

3. Method according to one of the preceding claims, **characterised in that** the soldering process is a melt diffusion soldering process.

4. Method according to one of the preceding claims, **characterised in that** the soldering process is implemented without flux.

5. Method according to one of the preceding claims, **characterised in that**, in order to form the solder layer, at least one solder partial layer is applied.

6. Method according to one of the preceding claims, **characterised in that**, in order to form the solder layer, two solder partial layers are applied.

7. Method according to one of the claims 5 and 6, **characterised in that** the solder partial layers are at least one high-melting and at least one low-melting solder partial layer.

8. Method according to claim 7, **characterised in that** the at least one high-melting solder partial layer is formed from at least one metal selected from the group comprising silver, gold, nickel and copper.

9. Method according to one of the claims 7 and 8, **characterised in that** the at least one low-melting solder partial layer is formed from at least one metal selected from the group comprising tin, indium and bismuth.

10. Method according to one of the claims 7-9, **characterised in that** firstly the at least one high-melting solder partial layer and then the at least one low-melting solder partial layer is deposited on the component layers.

11. Method according to one of the claims 5 - 10, **characterised in that** the composition and thickness of the solder partial layers are chosen such that during soldering an initial eutectic can be formed.

12. Method according to one of the preceding claims, **characterised in that** the component layers (16) are connected to each other by isothermal soldering.

13. Method according to one of the preceding claims, **characterised in that** the component layers (16) are connected to each other by simultaneous application of heat and contact pressure.

14. Method according to one of the preceding claims, **characterised in that** the component layers (16) are connected to each other by at least one rapid method selected from the group comprising heating-up and cooling-down.

15. Method according to one of the preceding claims, **characterised in that** soldering is implemented at a temperature in the range of 100 to 600°C, at a pressure, under which the stack is compressed, of at least 0.1 MPa, with a holding time in the range of 0 to 60 min and a temperature treatment is implemented with a tempering time in the range of 0 to 60 min.

16. Method according to one of the preceding claims, **characterised in that** at least one layer, selected from the group comprising multifunctional barrier layers, high-melting solder partial layers and low-melting solder partial layers, are formed by means of galvanochemical methods.

17. Method according to one of the preceding claims, **characterised in that** the component layers (16) are soldered in multiple printed panels.

18. Method according to one of the preceding claims, **characterised in that** the component layers (16) are soldered in a circuit board laminating press.

19. Method according to one of the preceding claims, **characterised in that**, during soldering, material plates or layers or films which are made of a material selected from the group comprising metals, ceramics, graphite and composite materials are used as pressure tools (1).

20. Method according to one of the preceding claims, **characterised in that**, during soldering, ceramic fleece is used as a pressure cushion (2).

21. Method according to one of the preceding claims, **characterised in that**, during soldering, registration devices (9), registration pins (4) or templates (7) are used for registration.

22. Method according to claim 21, **characterised in that** the registration devices (9), registration pins (4) or templates (7) comprise a material selected from the group comprising graphite, ceramics and metal.

23. Method according to one of the preceding claims, **characterised in that**, during soldering, structural features of the component layers (16) are used for auto-registration.

24. Method according to one of the preceding claims, **characterised in that**, after the soldering process, the component layers (16) are isolated by cutting, milling, punching or laser-cutting.

25. Microstructured component (3) selected from the group comprising microreactors, micromixers and micro-heat exchangers comprising a stack of microstructured component layers (16) which are connected to each other and comprise materials selected from the group including metals and metal alloys, **characterised in that** the component comprises at least one multifunctional barrier layer and a solder layer between the individual component layers (16), and **in that** the multifunctional barrier layer comprises at least one metal selected from the group comprising molybdenum, manganese, chromium, palladium, iron, nickel and alloys of at least one metal selected from the group comprising iron and nickel with phosphorus.

26. Microstructured component according to claim 25, **characterised in that** the materials are selected from the group comprising aluminium, aluminium alloys, copper, copper alloys and stainless steels.

27. Microstructured component according to one of the claims 25 and 26, **characterised in that** the component layers (16) are connected to each other by a melt diffusion soldering process.

28. Microstructured component according to one of the claims 25 - 27, **characterised in that** the solder layer comprises at least one high-melting and at least one low-melting metal.

29. Microstructured component according to claim 28, **characterised in that** the at least one high-melting metal is selected from the group comprising gold, silver, nickel and copper.

30. Microstructured component according to one of the claims 28 and 29, **characterised in that** the at least one low-melting metal is selected from the group comprising tin, indium and bismuth.

31. Microstructured component according to one of the claims 25 - 30, **characterised in that** the component layers (16) are soldered in multiple printed panels.

## Revendications

1. Procédé d'assemblage de couches de composants microstructurés (16) constituées de matériaux, sélectionnés dans un groupe composé de métaux et d'alliages métalliques, destinés à la fabrication de micro-réacteurs, de micro-mélangeurs et de micro-échangeurs de chaleur (3), les couches de composants (16) étant empilées puis brasées sous l'action de la chaleur, **caractérisé en ce que**, au moins sur des surfaces d'assemblage des couches de composants (16), au moins une couche de protection multifonctionnelle est appliquée et sur cette couche de protection, une couche de brasage est appliquée et **en ce que** la couche de protection multifonctionnelle est constituée d'au moins un métal sélectionné dans le groupe constitué du molybdène, du manganèse, du chrome, du palladium, du fer, du nickel et d'alliages d'au moins un métal sélectionné dans le groupe comprenant le fer et le nickel, avec du phosphore.

2. Procédé selon la revendication 1, **caractérisé en ce que** les matériaux sont sélectionnés dans le groupe comprenant l'aluminium, des alliages d'aluminium, le cuivre, des alliages de cuivre et des aciers inoxydables.

3. Procédé selon l'une quelconque des revendications précédentes, **caractérisé en ce que** le procédé de soudure est un procédé de brasage par fusion et diffusion.

4. Procédé selon l'une quelconque des revendications précédentes, **caractérisé en ce que** le procédé de brasage est effectué sans décapant.

5. Procédé selon l'une quelconque des revendications précédentes, **caractérisé en ce que**, pour la formation de la couche de brasage, au moins une couche partielle de brasage est appliquée.

6. Procédé selon l'une quelconque des revendications précédentes, **caractérisé en ce que**, pour la formation de la couche de brasage, deux couches partielles de brasage sont appliquées.

7. Procédé selon l'une des revendications 5 et 6, **caractérisé en ce que** les couches partielles de brasage sont au moins une couche partielle de brasage réfractaire et une couche partielle de brasage à bas point de fusion.

8. Procédé selon la revendication 7, **caractérisé en ce que** la couche partielle de brasage réfractaire est constituée d'au moins un métal sélectionné dans le groupe comprenant l'argent, l'or, le nickel et le cuivre.

9. Procédé selon l'une des revendications 7 et 8, **caractérisé en ce que** la couche partielle de brasage à bas point de fusion est constituée d'au moins un métal sélectionné dans le groupe comprenant l' étain, l'indium et le bismuth.

10. Procédé selon l'une quelconque des revendications 7 à 9, **caractérisé en ce que** la couche partielle réfractaire, tout d'abord, puis la couche partielle de brasage à bas point de fusion est ensuite déposée sur les couches de composants.

11. Procédé selon l'une quelconque des revendications 5 à 10, **caractérisé en ce que** la composition et l'épaisseur des couches partielles de brasage sont choisies de façon à ce qu'un eutectique initial puisse se former lors du brasage.

12. Procédé selon l'une quelconque des revendications précédentes, **caractérisé en ce que** les couches de composants (16) sont assemblées entre elles à l'aide d'un brasage isotherme.

13. Procédé selon l'une quelconque des revendications précédentes, **caractérisé en ce que** les couches de composants (16) sont assemblées entre elles à l'aide d'une application simultanée de chaleur et d'une pression.

14. Procédé selon l'une quelconque des revendications précédentes, **caractérisé en ce que** les couches de composants (16) sont assemblées entre elles à l'aide d'au moins un procédé rapide sélectionné dans le groupe comprenant le chauffage et le refroidissement.

15. Procédé selon l'une quelconque des revendications précédentes, **caractérisé en ce que**, à une température de l'ordre de 100 à 600°C, à une pression, à laquelle l'empilement est soumis, d'au moins 0,1 Mpa, avec un temps de maintien de l'ordre de 0 à 60 minutes, un brasage est effectué et, avec un temps de trempe de l'ordre de 0 à 60 minutes, un traitement thermique est effectué.

16. Procédé selon l'une quelconque des revendications précédentes, **caractérisé en ce qu'**au moins une couche sélectionnée dans le groupe comprenant les couches de protection multifonctionnelles, les couches partielles de brasage réfractaires et les couches partielles de brasage à bas point de fusion, sont formées à l'aide de procédés galvanotechniques.

17. Procédé selon l'une quelconque des revendications précédentes, **caractérisé en ce que** les couches de composants (16) sont brasées sur flan imprimé multiple.

18. Procédé selon l'une quelconque des revendications précédentes, **caractérisé en ce que** les couches de composants (16) sont brasées sur une presse de laminage de circuits imprimés.

19. Procédé selon l'une quelconque des revendications précédentes, **caractérisé en ce que**, lors du brasage, des plaques, des couches ou des films de matériaux sélectionnés dans le groupe comprenant des métaux, des céramiques, le graphite et des matériaux composites, sont utilisées en tant qu'outil de pressage (1).

20. Procédé selon l'une quelconque des revendications précédentes, **caractérisé en ce que**, lors du brasage, des non-tissés en céramique sont utilisés en tant qu'amortisseur de presse (2).

21. Procédé selon l'une quelconque des revendications précédentes, **caractérisé en ce que**, lors du brasage, des dispositifs enregistreurs (9), des goupilles d'enregistrement (4) ou des gabarits (7) sont utilisés pour l'enregistrement.

22. Procédé selon la revendication 21, **caractérisé en ce que** les dispositifs enregistreurs (9), les goupilles d'enregistrement (4) ou les gabarits (7) sont constitués d'un matériau sélectionné dans le groupe comprenant le graphite, la céramique et le métal.

23. Procédé selon l'une quelconque des revendications précédentes, **caractérisé en ce que**, lors du brasage, des caractéristiques de structures des couches de composants (16) sont utilisées pour un enregistrement automatique.

24. Procédé selon l'une des revendications précédentes, **caractérisé en ce que** les couches de composants (16) sont séparées après le processus de brasage par découpe, fraisage, poinçonnage ou laser.

25. Composant microstructuré (3) sélectionné dans le groupe constitué des micro-réacteurs, des micro-mélangeurs et des micro-échangeurs de chaleur, comprenant un empilement de couches de composants microstructurés (16) assemblés, constitués de matériaux sélectionnés dans le groupe comprenant des métaux et des alliages métalliques, **caractérisé en ce qu'**il comprend au moins une couche de protection multifonctionnelle ainsi qu'une couche de brasage entre les différentes couches de composants (16) et **en ce que** la couche de protection multifonctionnelle est constituée d'au moins un métal sélectionné dans le groupe comprenant le molybdène, le manganèse, le chrome, le palladium, le fer, le nickel et des alliages d'au moins un métal sélectionné dans le groupe comprenant le fer et le nickel, avec du phosphore.

26. Composant microstructuré selon la revendication 25, **caractérisé en ce que** les matériaux sont sélectionnés dans le groupe comprenant l'aluminium, des alliages d'aluminium, le cuivre, des alliages de cuivre et des aciers inoxydables.

27. Composant microstructuré selon l'une des revendications 25 et 26, **caractérisé en ce que** les couches de composants (16) sont assemblées entre elles à l'aide d'un procédé de brasage par fusion et diffusion.

28. Composant microstructuré selon l'une quelconque des revendications 25 à 27, **caractérisé en ce que** la couche de brasage est constituée d'au moins un métal réfractaire et d'un métal à bas point de fusion.

29. Composant microstructuré selon la revendication 28, **caractérisé en ce que** le métal réfractaire est sélectionné dans le groupe comprenant l'or, l'argent, le nickel et le cuivre.

30. Composant microstructuré selon l'une des revendications 28 et 29, **caractérisé en ce que** le métal à bas point de fusion est sélectionné dans le groupe comprenant l'étain, l'indium et le bismuth.

31. Composant microstructuré selon l'une quelconque des revendications 25 à 30, **caractérisé en ce que** les couches de composants (16) sont brasées sur flan imprimé multiple.
